# EUROPEAN PATENT APPLICATION

(11) **EP 2 180 772 A1**
(43) Date of publication of application: **28.04.2010**
(21) Application number: 07807279.0
(22) Date of filing: 13.09.2007
(51) Int. Cl.: H05K 3/46

(54) **MULTILAYERED WIRING BOARD AND SEMICONDUCTOR DEVICE**

(30) Priority: 24.08.2007 JP 2007219057
(71) Applicant: Sumitomo Bakelite Co., Ltd., Shinagawa-ku Tokyo 140-0002 (JP)
(72) Inventor: KONDO, Masayoshi, Akita-shi Akita 011-0951 (JP); KATO, Masaaki, Akita-shi Akita 011-0951 (JP); CHUMA, Toshiaki, Akita-shi Akita 011-0951 (JP); KOMIYATANI, Toshio, Akita-shi Akita 011-0951 (JP); IIDA, Takahisa, Akita-shi Akita 011-0951 (JP); KANEMASA, Kenichi, Tokyo 140-0002 (JP)
(74) Representative: Solf, Alexander
(86) International application number: PCT/JP2007/067872
(87) International publication number: WO 2009/028110

(57) **Abstract**

A multilayer wiring board includes: a rigid portion including a first base member having flexibility and surfaces, the first base member having a first insulating layer and a first conductor layer, and a second base member bonded on at least one of the surfaces of the first base member and having rigidity higher than that of the first base member, the second base member having a second insulating layer and a second conductor layer; and a flexible portion provided so as to be continuously extended from the rigid portion, the flexible portion constituted from the first base member, wherein in the case where a coefficient of thermal expansion of the second insulating layer is measured by a thermal mechanical analysis based on JIS C 6481 at a predetermined temperature, the coefficient of thermal expansion of the second insulating layer in a plane direction thereof is 13 ppm/°C or lower and the coefficient of thermal expansion of the second insulating layer in a thickness direction thereof is 20 ppm/°C or lower.

## Description

### TECHNICAL FIELD

The present invention relates to a multilayer wiring board and a semiconductor device.

### BACKGROUND ART

There is a multilayer printed circuit board (multilayer wiring board) including wirings for forming an electronic circuit by electrically connecting electronic parts such as semiconductor elements (e.g., IC chips, capacitors) mounted thereon. Examples of such a multilayer printed circuit board include a rigid board, a flexible printed board and a rigid flexible board.

The rigid board is a printed circuit board formed of a material having high rigidity. A semiconductor element mounted on such a rigid board hardly drops off therefrom due to heat, impact and the like, that is, a semiconductor device including such a rigid board hardly breaks down even if it is used for a long period of time. Therefore, the semiconductor device can have high mounting reliability.
However, since the rigid board has high rigidity as a whole, it cannot be used at a portion of an electronic device where any movable components are provided.

On the other hand, since the flexible printed board is formed of a material having flexibility, the flexible printed board can be provided or placed in an electronic device by folding or bending it. Namely, the flexible printed board has excellent placement flexibility. Therefore, such a flexible printed board can be used at a portion of an electronic device where any movable components are provided. Further, even in the case where the electronic device has a small size, the flexible printed board can be suitably used in such an electronic device by folding it.
However, the flexible printed board does not have sufficient resistance for external factors such as heat and impact. Therefore, the flexible painted board cannot have sufficient semiconductor element mounting reliability.

The rigid flexible board includes a rigid portion having high rigidity and a flexible portion having flexibility. In the rigid flexible board, electronic parts can be mounted on the rigid portion. Further, the rigid flexible board can be provided in an electronic device by folding it at the flexible portion. For these reasons, the rigid flexible board can be easily provided in various electronic devices, and hardly breaks down. Namely, the rigid flexible board can have both mounting reliability and placement flexibility.

Examples of the rigid flexible board include one in which a plurality of rigid boards are bonded to each other through flexible boards using terminals and the like, and one in which a part of a flexible sheet having a conductor circuit is put between members each having high rigidity (see, JP-A-2004-172473).
In the case of the former rigid flexible board, since the number of terminals which can be provided on the boards (sheets) is generally limited to a certain number, the number of signals capable of being transmitted through the terminals is limited. Further, connecting portions for connecting the terminals need to be provided on the rigid portion, a design of conductor circuit is limited. Therefore, it is difficult to produce an electronic device having high performance which is recently demanded.

On the other hand, in the case of the latter rigid flexible board, since signals are transmitted through wirings constituting the conductor circuit provided in the flexible sheet, it is not necessary to provide any terminals. Therefore, by constituting the conductor circuit from many wirings, many signals can be transmitted from the rigid portion to the flexible portion. Further, conductor circuits to be provided in both the rigid portion and the flexible portion can be designed more flexibly.
However, the rigid portion of such a rigid flexible board includes the flexible sheet. Therefore, the rigid portion is easily deformed due to external factors such as heat. As a result, the rigid flexible board cannot have high mounting reliability unlike the above-mentioned rigid board.

### DISCLOSURE OF THE INVENTION

An object of the present invention is to provide a Multilayer wiring board which has excellent semiconductor element mounting reliability and superior placement flexibility, and a semiconductor device having such a multilayer wiring board.

In order to achieve the object, a multilayer wiring board of the present invention comprises: a rigid portion including a first base member having flexibility and surfaces, the first base member having a first insulating layer and a first conductor layer, and a second base member bonded on at least one of the surfaces of the first base member and having rigidity higher than that of the first base member, the second base member having a second insulating layer and a second conductor layer; and a flexible portion provided so as to be continuously extended from the rigid portion, the flexible portion constituted from the first base member, wherein in the case where a coefficient of thermal expansion of the second insulating layer is measured by a thermal mechanical analysis based on JIS C 6481 at a temperature of 20 °C to a glass-transition temperature Tg₂ thereof [°C], which is measured using a dynamic viscoelastic apparatus based on JIS C 6481, the coefficient of thermal expansion of the second insulating layer in a plane direction thereof is 13 ppm/°C or lower and the coefficient of thermal expansion of the second insulating layer in a thickness direction thereof is 20 ppm/°C or lower.

This makes it possible to provide a multilayer wiring board which has excellent placement flexibility and high semiconductor element mounting reliability.

In the multilayer wiring board of the present invention, it is preferred that the glass-transition temperature Tg₂ [°C] of the second insulating layer is in the range of 200 to 280°C.

In the multilayer wiring board of the present invention, it is preferred that the rigid portion includes two second base members bonded to both surfaces of the first base member.

In the multilayer wiring board of the present invention, it is preferred that in the rigid portion, the number of the first insulating layer is in the range of 1 to 4 and the number of the second insulating layer is in the range of 2 to 10.

In the multilayer wiring board of the present invention, it is preferred that in the case where an average thickness of the first base member is defined as X [µm] and an average thickness of the second base member is defined as Y [µm], the X and the Y satisfy a relation of 1.5 ≤ Y/X ≤ 10.

In the multilayer wiring board of the present invention, it is preferred that in the case where an average thickness of the second base member is defined as Y [µm] and a tensile modulus of the second base member, which is obtained by a dynamic viscoelastic measurement, at 260°C is defined as Z [GPa], the Y and the Z satisfy a relation of 530 ≤ Y·Z ≤ 4300.

In the multilayer wiring board of the present invention, it is preferred that the second insulating layer is mainly constituted from a fibrous core material, a resin material and an inorganic filler.

In the multilayer wiring board of the present invention, it is preferred that the resin material contains cyanate resin and epoxy resin, and in the case where an amount of the cyanate resin contained in the resin material is defined as A [wt%] and an amount of the epoxy resin contained in the resin material is defined as B [wt%], the A and the B satisfy a relation of 0.1 ≤ B/A ≤ 1.0.

In the multilayer wiring board of the present invention, it is preferred that the resin material contains cyanate resin and phenolic resin, and in the case where an amount of the cyanate resin contained in the resin material is defined as A [wt%] and an amount of the phenolic resin contained in the resin material is defined as C [wt%], the A and the C satisfy a relation of 0.1 ≤ C/A ≤ 1.0.

In the multilayer wiring board of the present invention, it is preferred that the core material is mainly composed of glass fibers.

In the multilayer wiring board of the present invention, it is preferred that the second insulating layer has a through-hole extended so as to pass through the second insulating layer in the thickness direction thereof, and a conductor post formed inside the through-hole, and the first conductor layer and the second conductor layer are electrically connected to each other via the conductor post.

In the multilayer wiring board of the present invention, it is preferred that the conductor post includes a protruding terminal having one end electrically connected to the second conductor layer and the other end opposite to the one end provided so as to be protruded from the second insulating layer, and a metal coating layer coating the other end of the protruding terminal and electrically connected to the first conductor layer.

Further, in order to achieve the object, a semiconductor device of the present invention comprise: the multilayer wiring board defined of the present invention; and a semiconductor element electrically connected to a predetermined portion of the second conductor layer of the multilayer wiring board.

This makes it possible to provide a semiconductor device which has excellent placement flexibility and high semiconductor element mounting reliability.

### BRIEF DESCRIPTION OF THE DRAWINGS

FIG. 1 is a longitudinal section showing a first embodiment of a multilayer wiring board according to the present invention.
FIG. 2 is a longitudinal section showing a preferred method of manufacturing the multilayer wiring board shown in FIG. 1.
FIG. 3 is a longitudinal section showing an embodiment of a semiconductor device according to the present invention.
FIG. 4 is a longitudinal section showing a second embodiment of a multilayer wiring board according to the present invention.
FIG. 5 is a longitudinal section showing a preferred method of manufacturing the multilayer wiring board shown in FIG. 4.
FIG. 6 is a longitudinal section showing a preferred method of manufacturing the multilayer wiring board shown in FIG. 4.
FIG. 7 is a longitudinal section showing a preferred method of manufacturing the multilayer wiring board shown in FIG. 4.
FIG. 8 is a longitudinal section showing another embodiment of a semiconductor device according to the present invention.
FIG. 9 is a longitudinal section showing another embodiment of a semiconductor device according to the present invention.

### BEST MODE FOR CARRYING OUT THE INVENTION

Hereinbelow, description will be made on preferred embodiments of a multilayer wiring board and a semiconductor device according to the present invention.

### [First embodiment]

First, a first embodiment of the multilayer wiring board and the semiconductor device according to the present invention will be described.

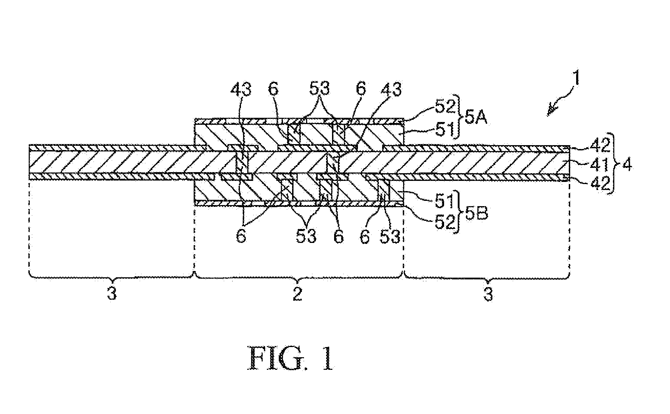

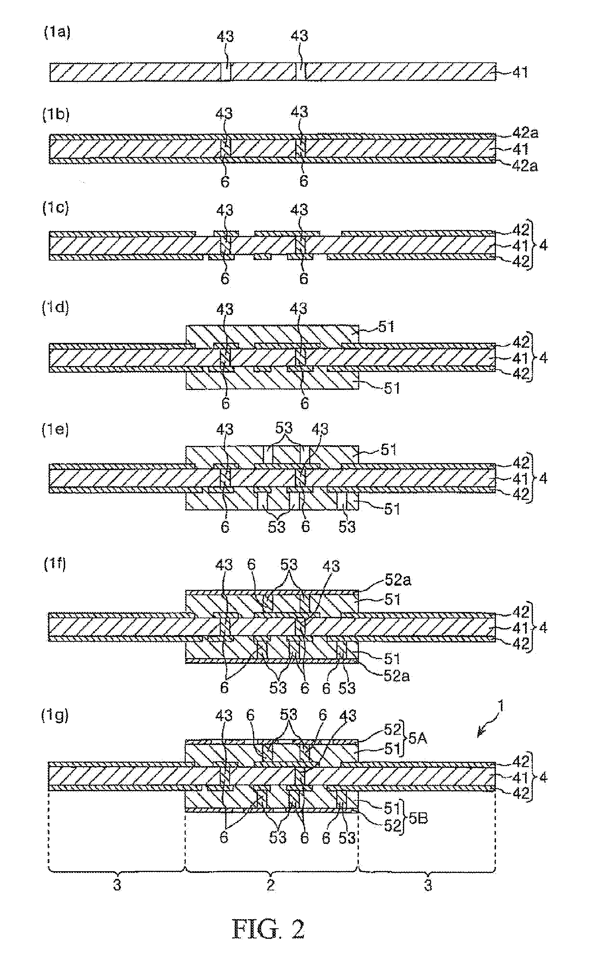

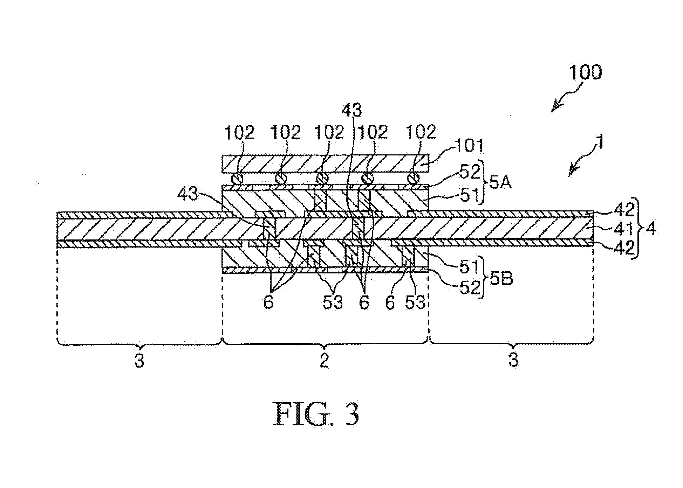

FIG. 1 is a longitudinal section showing the first embodiment of the multilayer wiring board according to the present invention, FIG. 2 is a longitudinal section showing a preferred method of manufacturing the multilayer wiring board shown in FIG. 1, and FIG. 3 is a longitudinal section showing an embodiment of the semiconductor device according to the present invention.
Further, hereinbelow, an upper side of each of FIGs. 1 and 2 is referred to as "upper" or "upper side" and a lower side thereof is referred to as "lower" or "lower side" for convenience of explanation.

As shown in FIG. 1, the multilayer wiring board 1 includes a rigid portion 2 having high rigidity and flexible portions 3 having flexibility and connected to both ends of the rigid portion 2.

### <Rigid portion>

First, the rigid potion 2 will be described.

As shown in FIG. 1, the rigid portion 2 has the high rigidity, and is constituted so as to be electrically connected to electronic parts such as semiconductor elements on outer surfaces thereof.

The rigid portion 2 has a first base member 4, a second base member 5A provided on an upper side of the first base member 4 and a second base member 5B provided on a lower side of the first base member 4.

### (First base member)

The first base member 4 is constituted from a first insulating layer 41 and first conductor layers 42 provided on both surfaces of the first insulating layer 41. Further, the first base member 4 has flexibility.

The first insulating layer 41 is formed of a material having an insulating property. Further, the insulating layer 41 has flexibility. This makes it possible to impart the flexibility to the first base member 4.

A constituent material of the first insulating layer 41 is not limited to a specific one as long as it has a high insulating property and can impart the flexibility to the first insulating layer 41. As the constituent material of the first insulating layer 41, a resin material can be used.

Examples of the resin material include polyimide, polyethylene terephthalate (PET), polyethylene naphthalate (PEN), polyether sulfone (PES), aromatic polyester (liquid crystal polymer), aromatic polyamide, and the like. These resin materials can be used singly or in combination of two or more of them.

Further, an average thickness of the first insulating layer 41 is preferably in the range of 5 to 100 µm, and more preferably in the range of 10 to 50 µm. This makes it possible for the first insulating layer 41 to have more excellent flexibility and more superior insulating property.

Furthermore, a coefficient of thermal expansion of the first insulating layer 41 in a plane direction thereof at a temperature of 100 to 190 °C is preferably in the range of 15 to 30 ppm/°C. This makes it possible to prevent large expansion of the first insulating layer 41 when the multilayer wiring board 1 is heated. As a result, it is possible to prevent warpage of the rigid portion 2 reliably.

Moreover, a coefficient of thermal expansion of the first insulating layer 41 in a thickness direction thereof at a temperature of 100 to 190 °C is preferably in the range of 15 to 30 ppm/°C. This makes it possible to prevent large expansion of the first insulating layer 41 when the multilayer wiring board 1 is heated. As a result, it is possible to prevent warpage of the rigid portion 2 reliably.

In this regard, it is to be noted that the semiconductor element mounting reliability of the multilayer wiring board 1 is affected by the coefficient of thermal expansion of the first insulating layer 41 when using the multilayer wiring board 1 on which the semiconductor element is mounted under a relatively high-temperature atmosphere. For this reason, the coefficient of thermal expansion of the first insulating layer 41 is defined by a coefficient of thermal expansion measured within the above-mentioned temperature range.

In the present specification, "coefficient of thermal expansion" is, unless otherwise noted, measured by a thermal mechanical analysis based on JIS C 6481. and refers to an average coefficient of thermal expansion within a temperature range in which the measurement is carried out.

The first conductor layers 42 are formed on both surfaces of the first insulating layer 41.

Each first conductor layer 42 functions as a circuit including a plurality of wirings.

A constituent material of each first conductor layer 42 is not limited to a specific one as long as it has conductivity. Examples of the constituent material of each first conductor layer 42 include various kinds of metals and alloys such as copper, copper-based alloy, aluminum and aluminum-based alloy.
In the case where the multilayer wiring board 1 is used for manufacturing a device to be applied to a high-frequency application, the constituent material of each first conductor layer 42 is preferably the copper or the copper-based alloy. Since the copper or the copper-based alloy has a relatively high electrical conductivity, it is appropriately used for such an application.

Further, an average thickness of each first conductor layer 42 is preferably in the range of 1 to 25 µm.

An average thickness of the first base member 4 constituted from the above-mentioned layers is preferably in the range of 7 to 150 µm, and more preferably in the range of 20 to 80 µm. This makes it possible to impart more excellent flexibility to the first base member 4 and to impart more superior rigidity to the rigid portion 2.

Further, a tensile modulus of the first base member 4 at a temperature of 25°C is preferably in the range of 0.1 to 10 GPa. This makes it possible to impart more excellent flexibility to the first base member 4. As a result, the flexible portions 3 which will be described below can have more excellent flexibility, and therefore the multilayer wiring board 1 can have more superior placement flexibility.
Further, by setting the tensile modulus of the first base member 4 to a value within the above range, it is possible to lower an effect on a tensile modulus (rigidity) of the rigid portion 2 as a whole.

In the present specification, "tensile modulus" refers to, unless otherwise noted, a value obtained by a measuring method based on IPC TM-6502.4.19.

Further, the first insulating layer 41 includes a plurality of through-holes 43 each extended so as to pass through the first insulating layer 41 in a thickness direction thereof. In the through-holes 43, conductor posts 6 each composed of a conductor member are provided. An upper end of each conductor post 6 makes contact with the first conductor layer 42 provided on an upper surface of the first insulating layer 41. Further, a lower end of each conductor post 6 makes contact with the first conductor layer 42 provided on a lower surface of the first insulating layer 41.
In such a structure, the first conductor layer 42 provided on the upper surface of the first insulating layer 41 and the first conductor layer 42 provided on the lower surface of the first insulating layer 41 are electrically connected to each other via the conductor posts 6.

### (Second base member)

A second base member 5A is provided so as to be bonded to an upper surface of the first base member 4. Further, a second base member 5B is provided so as to be bonded to a lower surface of the first base member 4.

Hereinbelow, since structures of the second base member 5A and the second base member 5B are substantially identical to each other, the second base member 5A will be described representatively.

The second base member 5A includes a second insulating layer 51 provided on the upper surface of the first base member 4, and a second conductor layer 52 on an upper side of the second insulating layer 51.

A coefficient of thermal expansion of such a second insulating layer 51 in a plane direction thereof at a temperature of 20°C to a glass-transition temperature Tg₂ [°C] of the second insulating layer 51 is 13 ppm/°C or lower, and a coefficient of thermal expansion of the second insulating layer 51 in a thickness direction thereof at a temperature of 20°C to the glass-transition temperature Tg₂ [°C] of the second insulating layer 51 is 20 ppm/°C or lower. The present invention is **characterized in that** the second insulating layer 51 has such a physical property.

By setting the coefficients of thermal expansion of the second insulating layer 51 in the plane and thickness directions thereof within to values within the above ranges, respectively, it is possible to prevent a semiconductor element mounted on the multilayer wiring board 1 from dropping off therefrom due to heat, impact and the like. Namely, the multilayer wiring board 1 can have excellent semiconductor element mounting reliability. It is conceived that the above fact is caused by the following reasons.

The semiconductor element, in general, has a relatively low coefficient of thermal expansion within the above-mentioned temperature range. Further, as described above, the second insulating layer 51 has a sufficiently low coefficient of thermal expansion. As a result, the coefficient of thermal expansion of the semiconductor element and that of the second insulating layer 51 become relatively close to each other.
Therefore, even in the case where the multilayer wiring board 1 on which the semiconductor element is mounted is heated and cooled many times, it is difficult for force to repeatedly apply to bonded portions formed between the semiconductor element and the second conductor layer 52 provided on the second insulating layer 51. This makes it possible to prevent the bonded portions from fatiguing, to thereby suppress occurrence of a defective electrical connection between the second conductor layer 52 and the semiconductor element.
Since the fatigue which would occur due to heat or the like is difficult to be accumulated in the bonded portions formed between the semiconductor element and the second conductor layer 52, bond strength therebetween is maintained in an initial condition. For these reasons, it is conceived that the semiconductor element hardly drops off from the second conductor layer 52.

Further, as described above, since the second insulating layer 51 has the sufficiently low coefficient of thermal expansion, it is hard to thermally expand when the multilayer wiring board 1 is heated. Therefore, even in the case where the first insulating layer 41 has a relatively high coefficient of thermal expansion, excessive thermal expansion of the second insulating layer 51 is prevented under the influence of the thermal expansion of the first insulating layer 41. This makes it possible to suppress warpage of the rigid portion 2 or the like.

On the other hand, if at least one of the coefficients of thermal expansion of the second insulating layer 51 in the plane and thickness directions thereof exceeds the above limit value, the coefficient of thermal expansion of the second insulating layer 51 and that of the semiconductor element (electronic part) become significantly different from each other. The bonded portions formed between the semiconductor element and the second conductor layer 52 are easily fatigued, so that the semiconductor element tends to drop off from the second conductor layer 52 easily.
In particular, in the case where the first insulating layer 41 has the relatively high coefficient of thermal expansion, it thermally expands remarkably. Therefore, there is a case that the second insulating layer 51 thermally expands excessively under the influence of the thermal expansion of the first insulating layer 41. In this case, warpage of the rigid portion 2 occurs easily.

The coefficient of thermal expansion of the second insulating layer 51 in the plane direction thereof at the temperature of 20°C to the glass-transition temperature Tg₂ [°C] may be within the above-mentioned range, but is preferably in the range of 3 to 13 ppm/°C, and more preferably in the range of 3 to 12 ppm/°C. This makes it possible to obtain the above-mentioned effects more remarkably.

The coefficient of thermal expansion of the second insulating layer 51 in the thickness direction thereof at the temperature of 20°C to the glass-transition temperature Tg₂ [°C] may be within the above-mentioned range, but is preferably in the range of 3 to 20 ppm/°C, and more preferably in the range of 3 to 18 ppm/°C. This makes it possible to obtain the above-mentioned effects more remarkably.

Further, change of the coefficient of thermal expansion of the second insulating layer 51 becomes large under the atmosphere having a temperature higher than the glass-transition temperature Tg₂ [°C]. In addition, the multilayer wiring board 1 is, in general, used within the above-mentioned range. For this reason, the coefficient of thermal expansion of the second insulating layer 41 is defined by a coefficient of thermal expansion measured within such a temperature range.

Furthermore, the glass-transition temperature Tg₂ [°C] of the second insulating layer 51 measured based on JIS C 6481 is preferably in the range of 200 to 280°C, and more preferably in the range of 230 to 270°C. This makes it possible to impart more excellent heat resistance to the second insulating layer 51. This also makes it possible to make the coefficient of thermal expansion of the second insulating layer 51 low within a wide temperature range, and to make rigidity thereof higher. Therefore, even in the case where the multilayer wiring board 1 is used under the harsh environment, it can maintain more excellent mounting reliability.

In this regard, it is to be noted that "glass-transition temperature" refers to, unless otherwise noted, a peak value of tan δ measured using a dynamic viscoelastic apparatus based on JIS C 6481.

Further, an average thickness of the second insulating layer 51 is preferably in the range of 10 to 300 µm, and more preferably in the range of 30 to 200 µm. This makes it possible to make the thickness of the rigid portion 2 sufficiently thin, while maintaining rigidity of the second base member 5A higher.

Furthermore, the second insulating layer 51 may be formed from any materials, but is preferably mainly formed from a fibrous core material (fiber base member), a resin material and an inorganic filler. By forming the second insulating layer 51 from such a material, it is possible to set the coefficient of thermal expansion of the second insulating layer 51 within the abode-mentioned range more easily.

The core material is used as a core of the second insulating layer 51. In the case where the second insulating layer 51 includes such a core material, it is possible to impart high rigidity and an excellent insulating property to the second insulating layer 51.

Examples of the core material include: a glass fiber base member made of glass fibers such as a glass woven cloth or a glass non-woven cloth; a synthetic fiber base member formed from a woven or non-woven cloth mainly made of polyamide-based resin fibers (e.g., polyamide resin fibers, aromatic polyamide resin fibers and wholly aromatic polyamide resin fibers), polyester-based resin fibers (e.g., polyester resin fibers, aromatic polyester resin fibers and wholly aromatic polyester resin fibers), polyimide resin fibers or fluorocarbon resin fibers; a paper base member mainly formed from kraft paper, cotton linter paper or blended paper of linter and kraft pulp; and the like.
Among these fiber base members, the glass fiber base member is preferably used. By using such a glass fiber base member, it is possible to improve the rigidity of the second insulating layer 51 and to reduce the thickness of the second insulating layer 51. In addition, it is also possible to lower the coefficient of thermal expansion of the second insulating layer 51. This makes it possible to suppress occurrence of warpage of a substrate manufactured using the second insulating layer 51.

Examples of glass for forming the glass fiber base member include E glass, C glass, A glass, S glass, D glass, NE glass, T glass, H grass, and the like. Among these glasses, the T glass is preferably used. By using such a T glass, it is possible to lower a coefficient of thermal expansion of the glass fiber base member. This makes it possible to lower the coefficient of thermal expansion of the second insulating layer 51.

Further, an amount of the core material contained in the second insulating layer 51 is preferably in the range of 30 to 70 wt%, and more preferably in the range of 40 to 60 wt%. This makes it possible to make electric insulation and the coefficient of thermal expansion of the second insulating layer 51 sufficiently low, while preventing damages of the second insulating layer 51 such as crack thereof.

In the second insulating layer 51, the resin material exists around the core material or is impregnated into the core material. Further, the resin material also functions as a binder (binding resin) for the inorganic filler which will be described.

The resin material constituting the second insulating layer 51 is not limited to any specific one, but preferably contains, for example, a thermosetting resin. This makes it possible to improve heat resistance of the second insulating layer 51.

Examples of the thermosetting resin include: phenolic resin such as novolak type phenolic resin (e.g., phenol novolak resin, cresol novolak resin, bisphenol A novolak resin), or resol type phenolic resin (e.g., non-modified resol phenolic resin, oil-modified resol phenolic resin modified with oil such as wood oil, linseed oil or walnut oil); epoxy resin such as bisphenol type epoxy resin (e.g., bisphenol A epoxy resin, bisphenol F epoxy resin), novolak type epoxy resin (e.g., novolak epoxy resin, cresol novolak epoxy resin), or biphenyl type epoxy resin; urea resin; triazine ring-containing resin such as melamine resin; unsaturated polyester resin; bismaleimide resin; polyurethane resin; diallylphthalate resin; silicone resin; benzoxazine ring-containing resin; cyanate resin; and the like.

Among these thermosetting resins, the cyanate resin is more preferably used. By using such cyanate resin, it is possible to sufficiently lower the coefficient of thermal expansion of the second insulating layer 51. In addition, it is also possible for the second insulating layer 51 to have excellent electric properties such as low-dielectric constant and low-dielectric loss tangent.

The cyanate resin can be obtained by, for example, thermally curing a prepolymer produced through a reaction of cyanogen halide with phenol. Specifically, examples of such cyanate resin include novolak type cyanate resin, bisphenol type cyanate resin such as bisphenol A type cyanate resin, bisphenol E type cyanate resin or tetramethyl bisphenol F type cyanate resin, and the like.
Among these cyanate resins, the novolak type cyanate resin is preferably used. By using the novolak type cyanate resin, it is possible to further improve heat resistance and flame retardancy of the second insulating layer 51 due to increase of a crosslinking density of the resin material in the second insulating layer 51. This is because the novolak type cyanate resin has triazine rings and because it has a high content of benzene rings due to its structure, thereby easily carbonizing the benzene rings contained therein.
In addition, by using the novolak type cyanate resin, it is also possible to impart excellent rigidity to the second insulating layer 51, even in the case where the second insulating layer 51 has a reduced thickness (e.g., 35 µm or less). The second insulating layer 51 offers excellent rigidity particularly upon heating, and therefore it offers especially excellent reliability when a semiconductor element is mounted thereon.

As the prepolymer of the novolak type cyanate resin, one represented by, for example, the following formula (I) can be used.

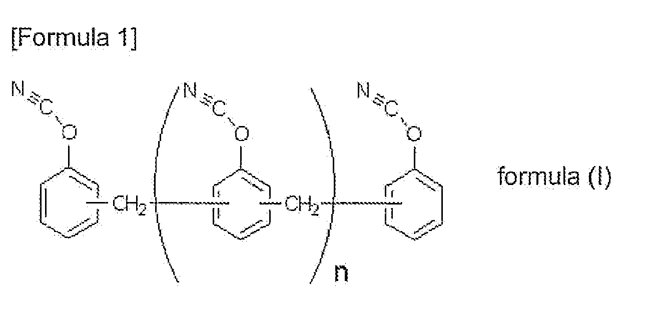

wherein "n" is any integer.

An average number of repeating units "n" of the prepolymer of the novolak type cyanate resin represented by the above formula (I) is not limited to a specific value, but is preferably in the range of 1 to 10, and more preferably in the range of 2 to 7.

A weight-average molecular weight of the prepolymer of the cyanate resin is not limited to a specific value, but is preferably in the range of 500 to 4,500, and more preferably in the range of 600 to 3,000.

In this regard, it is to be noted that the weight-average molecular weight of a resin, a prepolymer or the like can be measured using, for example, a GPC (gel permeation chromatography).

The GPC measurement is carried out by, for example, using HLC-8200GPC (produced by TOSOH CORPORATION) as measurement equipment, TSK=GEL polystyrene as a column and THF (tetrahydrofuran) as a solvent.

An amount of the cyanate resin contained in the second insulating layer 51 is not limited to a specific value, but is preferably in the range of 2 to 25 wt%, and more preferably in the range of 10 to 20 wt%. If the amount of the cyanate resin is less than the above lower limit value, there is a case that it becomes difficult to form the second insulating layer 51. On the other hand, if the amount of the cyanate resin exceeds the above upper limit value, there is a case that mechanical strength of the second insulating layer 51 is lowered.

Further, the resin material constituting the second insulting layer 51 can contain epoxy resin. In particular, in the case where the cyanate resin (especially, novolak type cyanate resin) is used as the thermosetting resin, an epoxy resin containing substantially no halogen atom is preferably used in combination with the cyanate resin. This makes it possible to improve solder heat resistance after moisture absorption and flame retardancy of the second insulating layer 51.

Examples of the epoxy resin include phenol novolak type epoxy resin, bisphenol type epoxy resin, naphthalene type epoxy resin, aryl alkylene type epoxy resin, and the like. Among these epoxy resins, the aryl alkylene type epoxy resin is preferably used. By using such an aryl alkylene type epoxy resin, it is possible to further improve the solder heat resistance after moisture absorption and the flame retardancy of the second insulating layer 51.

The aryl alkylene type epoxy resin is an epoxy resin having one or more aryl alkylene groups in one repeating unit. Examples of such an aryl alkylene type epoxy resin include xylylene type epoxy resin, biphenyl dimethylene type epoxy resin, and the like. Among these aryl alkylene type epoxy resins, the biphenyl dimethylene type epoxy resin is preferably used. A prepolymer of the biphenyl dimethylene type epoxy resin can be represented by, for example, the following formula (II).

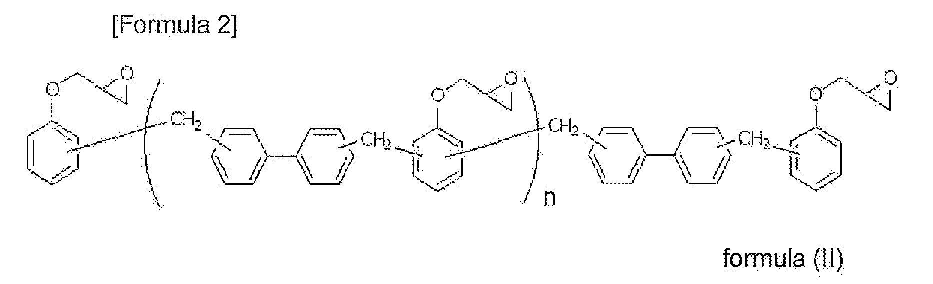

wherein "n" is any integer.

An average number of repeating units "n" of the prepolymer of the biphenyl dimethylene type epoxy resin represented by the above formula (II) is not limited to a specific value, but is preferably in the range of 1 to 10, and more preferably in the range of 2 to 5.

An amount of the epoxy resin contained in the second insulating layer 51 is not limited to a specific value, but is preferably in the range of 0.5 to 27 wt%, and more preferably in the range of 2 to 20 wt%. If the amount of the epoxy resin is less than the above lower limit value, there is a case that sufficient mechanical strength of the second insulating layer 51 can be obtained. On the other hand, if the amount of the epoxy resin exceeds the above upper limit value, there is a case that heat resistance of the second insulating layer 51 is lowered.

In particular, in the case where the resin material contains the cyanate resin and the epoxy resin, when the amount of the cyanate resin contained in the resin material is defined as A [wt%] and the amount of the epoxy resin contained in the resin material is defined as B [wit%], the A and the B satisfies preferably a relation of 0.1 ≤ B/A ≤ 1.0, and more preferably a relation of 0.15 ≤ B/A ≤ 0.5. This makes it possible to impart more excellent heat resistance as well as more superior physical strength (flexural rigidity) to the second insulating layer 51. As a result, the multilayer wiring board 1 can have more excellent electronics part mounting reliability.

A weight-average molecular weight of the epoxy resin is not limited to a specific values, but is preferably in the range of 500 to 20,000, and more preferably in the range of 800 to 15,000.

Further, the resin material can contain phenolic resin. In particular, in the case where the cyanate resin (especially, novolak type cyanate resin) is used as the thermosetting resin, the phenolic resin is preferably used in combination with the cyanate resin. This makes it possible to improve solder heat resistance after moisture absorption of the second insulating layer 51.

Examples of the phenolic resin include novolak type phenolic resin, resol type phenolic resin, aryl alkylene type phenolic resin, and the like. Among these phenolic resins, the aryl alkylene type phenolic resin is preferably used. By using such an aryl alkylene type phenolic resin, it is possible to further improve the solder heat resistance after moisture absorption of the second insulating layer 51.

Examples of the aryl alkylene type phenolic resin include xylylene type phenolic resin, biphenyl dimethylene type phenolic resin, and the like. A prepolymer of the biphenyl dimethylene type phenolic resin can be represented by, for example, the following formula (III).

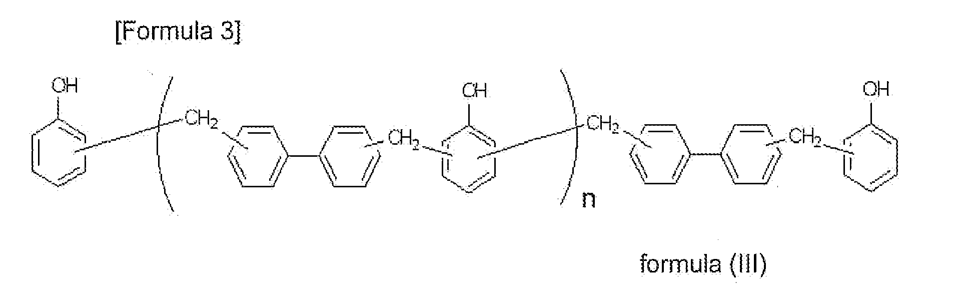

wherein "n" is any integer.

An average number of repeating units "n" of the prepolymer of the biphenyl dimethylene type phenolic resin represented by the above formula (III) is not limited to a specific value, but is preferably in the range of 1 to 12, and more preferably in the range of 2 to 8.

An amount of the phenolic resin contained in the second insulating layer 51 is not limited to a specific value, but is preferably in the range of 0.5 to 27 wt%, and more preferably in the range of 2 to 20 wt%. If the amount of the phenolic resin is less than the above lower limit value, there is a case that heat resistance of the second insulating layer 51 is lowered. On the other hand, if the amount of the phenolic resin exceeds the above upper limit value, there is a case that the coefficient of thermal expansion of the second insulating layer 51 is difficult to be set to the above-mentioned range depending on the kind of the phenolic resin used.

A weight-average molecular weight of a prepolymer of the phenolic resin is not limited to a specific value, but is preferably in the range of 400 to 18,000, and more preferably in the range of 500 to 15,000.

By using the cyanate resin (especially, novolak type cyanate resin) and the aryl alkylene type phenolic resin in combination, it is possible to control a crosslinking density of the resin material, thereby improving adhesiveness between metal and resin. This makes it possible to maintain connection between conductor layers and connection between the second conductor layer 52 and an electronic part reliably, As a result, the multilayer wiring board 1 can have more excellent electronic part mounting reliability.

Further, in the case where the resin material contains the cyanate resin and the phenolic resin, when the amount of the cyanate resin contained in the resin material is defined as A [wt%] and the amount of the phenolic resin contained in the resin material is defined as C [wt%], the A and the C satisfies preferably a relation of 0.1 ≤ C/A ≤ 1.0, and more preferably a relation of 0.15 ≤ C/A ≤ 0.5. This makes it possible to set the coefficient of thermal expansion of the second insulating layer 51 to the above-mentioned range more reliably, thereby further improving heat resistance of the second insulating layer 51. As a result, the multilayer wiring board 1 can have more excellent electronic part mounting reliability.

Furthermore, by using the cyanate resin (especially, novolak type cyanate resin), the phenolic resin (aryl alkylene type phenolic resin, especially, biphenyl dimethylene type phenolic resin), and the epoxy resin (aryl alkylene type epoxy resin, especially, biphenyl dimethylene type epoxy resin) in combination, it is possible to obtain a multilayer wiring board 1 having especially excellent dimensional stability. Such a multilayer wiring board 1 can have especially excellent electronic part mounting reliability.

A glass-transition temperature of the resin material, which is measured based on JIS K 7121 is preferably in the range of 200 to 280°C, and more preferably in the range of 230 to 270°C.

Further, in the case where the amount of the resin material contained in the second insulating layer 51 is defined as S [wt%] and the amount of the core material contained in the second insulating layer 51 is defined as T [we%], the S and the T satisfies preferably a relation of 1.5 ≤ T/S, and more preferably a relation of 1.8 ≤ T/S ≤ 2.4.
This makes it possible to set the coefficient of thermal expansion of the second insulating layer 51 to a value within the above-mentioned range more reliably, thereby further improving an electrical insulating property and heat resistance of the second insulating layer 51. As a result, the multilayer wiring board 1 can have more excellent electronic part mounting reliability.

In addition, the second insulating layer 51 preferably contains an inorganic filler. This makes it possible to obtain a second insulating layer 51 having high mechanical strength even in the case where it is formed so as to have a thin thickness (e.g., 35 µm or less). This also makes it possible to set the coefficient of thermal expansion of the second insulating layer 51 to a value within the above-mentioned range more easily.

Examples of the inorganic filler include talc, alumina, glass, silica, mica, aluminum hydroxide, magnesium hydroxide, and the like. Among these inorganic fillers, the silica is preferably used. From the viewpoint of excellent low thermal expansivity, fused silica (especially, spherical fused silica) is preferably used.

Examples of a shape of the silica includes a crushed shape, a spherical shape and the like. Among them, in the case where the spherical silica is used, when the resin materials and such a silica are mixed with each other in production of the second insulating layer 51 to obtain a mixture (resin vanish), it is possible to lower a viscosity of the mixture, thereby impregnating the mixture into the core material more easily.

An average particle size of the inorganic filler is not limited to a specific value, but is preferably in the range of 0.05 to 2.0 µm, and more preferably in the range of 0.1 to 1.0 µm. This makes it possible to disperse the inorganic filler into the second insulating layer 51 more uniformly, thereby further improving physical strength and an insulating property of the second insulating layer 51.

The average particle size of the inorganic filler can be measured by, for example, a particle size distribution analyze ("LA-500" produced by HORIBA).

In this specification, the average article size means an average particle size based on volume.

An amount of the inorganic filler contained in the second insulating layer 51 is not limited to a specific value, but is preferably in the range of 10 to 35 wt%, and more preferably in the range of 15 to 25 wt%. By setting the amount of the inorganic filler to a value within the above range, it is possible to impart a sufficiently low coefficient of thermal expansion and an especially low water-absorption property to the second insulating layer 51.

In the case where the amount of the resin material contained in the second insulating layer 51 is defined as S [wt%] and an amount of the inorganic filler contained in the second insulating layer 51 is defined as U [wt%], the S and the U satisfies preferably a relation of 0.6 ≤ U/S, and more preferably a relation of 0.8 ≤ U/S ≤ 1.4.
This makes it possible to set the coefficients of thermal expansion of the second insulating layer 51 to a value within the above-mentioned range more reliably, thereby further improving heat resistance of the second insulating layer 51. As a result, the multilayer wiring board 1 can have more excellent electronic part mounting reliability.
Further, this also makes it possible to easily prepare the resin varnish which will be described in production of the second insulating layer 51. Therefore, the second insulating layer 51 can have reduced ununiformity in rigidity and an electrical insulating property thereof.

Further, the second insulating layer 51 may contain a thermoplastic resin such as phenoxy resin, polyimide resin, polyamideimide resin, polyphenylene oxide resin or polyethersulfone resin.

Furthermore, if necessary, the second insulating layer 51 may contain additives in addition to the above-described components. Examples of such additives include a pigment, an antioxidant, and the like.

The conductor layer 52 is provided on the second insulating layer 51.

The conductor layer 52 is constituted from a plurality of wirings, and thus functions as a circuit.

Further, the conductor layer 52 is located on the most surface side of the rigid portion 2. In this structure, an electronic part such as a semiconductor element can be electrically connected to (mounted on) the conductor layer 52.

A constituent material of the second conductor layer 52 is not limited to a specific type as long as it has conductivity. Examples of the constituent material of the second conductor layer 52 include various kinds of metals and alloys such as copper, copper-based alloy, aluminum and aluminum-based alloy.
In the case where the multilayer wiring board is used for manufacturing a device to be applied to a high-frequency application, the constituent material of the second conductor layer 52 is preferably the copper or the copper-based alloy. Since the copper or the copper-based alloy has a relatively high electrical conductivity, it is appropriately used for such an application.

An average thickness of the second conductor layer 52 is preferably in the range of 1 to 50 µm.

Further, the second insulating layer 51 includes a plurality of through-holes 53 each extended so as to pass through the second insulating layer 51 in a thickness direction thereof. In each through-hole 53, a conductor post 6 composed of a conductor member is provided. A lower end of each conductor post 6 makes contact with the first conductor layer 42 provided on the upper surface of the first insulating layer 41.
On the other hand, an upper end of each conductor post 6 makes contact with the second conductor layer 52 provided on the upper surface of the second insulating layer 51. In such a structure, the first conductor layer 42 and the second conductor layer 52 can be electrically connected to each other via the conductor posts 6.

An average thickness of the second base member 5A is preferably in the range of 15 to 500 µm, and more preferably in the range of 30 to 200 µm. This makes it possible to impart more excellent rigidity to the second base member 5A and to make a thickness of the rigid portions 2 sufficiently thinner.

In the case where the average thickness of the first base member 4 is defined as X [µm] and the average thickness of the second base member 5A is defined as Y [µm], the X and the Y satisfy preferably a relation of 1.5 ≤ Y/X ≤ 10, and more preferably a relation of 2 ≤ Y/X ≤ 5. This makes it possible to impart more excellent rigidity to the rigid portion 2 and to make the thickness of the rigid portion 2 sufficiently thiner.

Further, in the case where a tensile modulus of the second base member 5A is measured by a dynamic viscoelastic measurement, the tensile modulus of the second base member 5A at a temperature of 260°C is preferably in the range of 10 to 50 GPa, and more preferably in the range of 15 to 30 GPa.
This makes it possible to impart sufficiently high rigidity to the rigid portion 2 and to make the thickness of the rigid portion 2 thiner. Therefore, the multilayer wiring board 1 can have more excellent electronic part mounting reliability and more superior placement flexibility.
In the case where, in general, electronics parts such as semiconductor elements are mounted on a printed wiring board using a solder by a reflow method, the solder provided on the printed wiring board is melted by being heated up to a temperature of about 260°C.
At this time, heat is also applied to the printed wiring board, and thus there is a case that defects such as warpage occur in the printed wiring board. However, even in such a case, warpage of the multilayer wiring board 1 which would occur due to the heat in semiconductor mounting can be prevented reliably, because the second base member 5A has the above-mentioned tensile modulus.

As described above, the rigidity of the second base member 5A is higher than that of the first base member 4. Specifically, the tensile modulus of the second base member 5A, which is obtained by the dynamic viscoelastic measurement, at 25°C is higher than that of the first base member 4 at 25°C.

In the case where the average thickness of the second base member 5A is defined as Y [µm] and the tensile modulus of the second base member 5A, which is obtained by the dynamic viscoelastic measurement, at 260°C is defined as Z [GPa], the Y and the Z satisfy preferably a relation of 530 ≤ Y·Z ≤ 4300, and more preferably a relation of 1000 ≤ Y·Z ≤ 3400.
This makes it possible to impart sufficiently high rigidity to the rigid portion 2. Therefore, the multilayer wiring board 1 can have more excellent electronic part mounting reliability and more superior placement flexibility.

Further, in this embodiment, the rigid portion 2 includes the second base members 5A and 5B each having the excellent rigidity and the sufficiently low coefficient of thermal expansion which are provided on both surfaces of the first base member 4. in such a structure, deformation or warpage of the rigid portion 2 which would occur due to heat or physical force can be prevented remarkably. Therefore, the multilayer wiring board 1 can have more excellent electronic part mounting reliability.

### <Flexible portion>

### Next, the flexible portion 3 will be described.

The flexible portions 3 are provided so as to be continuously extended from the rigid portion 2 and constituted from the first base member 4. Since the first base member 4 has the flexibility, the flexible portions 3 can be inflected in the multilayer wiring board 1. This makes it possible to appropriately arrange the multilayer wiring board 1 to, for example, an operated portion of an electronic device. Further, the multilayer wiring board 1 can be provided in, for example, a relatively narrow space existing in the electronic device so as to be inflected. Namely, the multilayer wiring board 1 can have superior placement flexibility.

Further, the first base member 4 constituting the flexible portions 3 is obtained by extending the first base member 4 provided in the rigid portion 2. The multilayer wiring board 1 of the present invention can transmit signals from the rigid portion 2 to the flexible portions 3 using the first base member 4 as a whole unlike the conventional rigid flexible board in which the flexible portion and the rigid portions are connected to each other via the terminals. In other words, the first base member 4 can transmit many signals from the rigid portion 2 to the flexible portions 3.

### <Method of manufacturing multilayer wiring board>

Next, description will be made on one example of a method of manufacturing the multilayer wiring board 1.

First, the first insulating layer 41 is prepared (see, FIG. 2(1a)). The first insulating layer 41 can be obtained by forming the above-mentioned constituent material of the first insulating layer 41 in a sheet shape, and then forming the through-holes 43 so as to pass through the sheet-shaped constituent material in a thickness direction thereof.

A method of forming the through-holes 43 is not limited to a specific one. For example, the through-holes 43 can be formed by providing a metal layer having opening portions each corresponding to the through-hole 43 on the sheet-shaped constituent material, and then irradiating the sheet-shaped constituent material with laser through the metal layer. By using such a method, it is possible to form the through-holes 43 in an excellent laser workability.
Namely, since the metal layer is provided on the sheet-shaped constituent material so as to coat surrounds of portions to be removed for forming the through-holes 43, it is possible to prevent the surrounds of the portions from being deteriorated due to generation of an interference wave of the laser or the like (that is, it is possible to prevent openings of the through-holes 43 from being needlessly enlarged). In addition, it is also possible to suppress generation of smear.

Examples of the laser to be used includes CO₂ laser, UV-YAG laser, and the like.

Further, it is preferred that the laser is irradiated under the conditions that it passes through the sheet-shaped constituent material. This makes it possible to reduce an effect of the interference wave of the laser on the sheet-shaped constituent material.

Furthermore, the through-holes 43 may be formed using, for example, a drill or the like.

Moreover, the metal layer can be removed using, for example, an etching or the like after the through-holes 43 have been formed.

An opening diameter of an upper side of each through-hole 43 is not limited to a specific value, but is preferably in the range of 55 to 85 µm, and more preferably in the range of 60 to 70 µm. On the other hand, an opening diameter of a lower side of each through-hole 43 is not limited to a specific value, but is preferably in the range of 35 to 65 µm, and more preferably in the range of 50 to 60 µm. By setting the opening diameter of each through-hole 43 to a value within the above range, it is possible to fill the through-holes 43 with the conductor posts 6 more reliably.

Next, cylindrical conductor posts 6 are formed into the through-holes 43, respectively, and metal layers 42a are formed onto surfaces of the first insulating layers 41, respectively (see, FIG. 2(1b)).
Examples of a method of forming the conductor posts 6 include a method in which the through-holes 43 are filled with a conductive paste, a method in which the through-holes 43 are filled with a conductive material using an electroless plating, a method in which the through-holes 43 are filled with a conductive material using an electrolytic plating, and the like.
Among them, the method in which the through-holes 43 are filled with the conductive material using the electrolytic plating is preferably used. The use of such a method is preferable in that the metal layers 42a can be formed on the surfaces of the first insulating layers 41 while forming the conductor posts 6 into the through-hoies 43.

Thereafter, each metal layer 42a is subjected to an etching treatment or the like to form the first conductor layer (circuit pattern) 42. In this way, the first base member 4 is obtained (see, FIG. 2(1c)).

Next, the second insulating layers 51 are laminated on both surfaces of the first base member 4 (see, FIG. 2(1d)).

Each second insulating layer 51 formed as follows can be used.

First, a resin varnish in which the resin material (including the prepolymer) and the inorganic filler are mainly dissolved and/or dispersed into an organic solvent is prepared.

The resin varnish may contain a coupling agent. The coupling agent can improve wettability of an interface between the thermosetting resin and the inorganic filler. This makes it possible to uniformly fix the thermosetting resin and the inorganic filler to the core material. As a result, it is possible to improve heat resistance of the second insulating layer 51, especially, solder heat resistance after moisture absorption of the second insulating layer 51.

If necessary, the resin varnish may contain a curing accelerator. This makes it possible to more easily cure the above-mentioned thermosetting resin in the production of the second insulating layer 51. As the curing accelerator, a well-known one can be used.

Next, a prepreg is obtained by immersing the core material into the resin varnish, and then removing the organic solvent from it (drying it). The second insulating layer 51 can be formed by curing a single prepreg or a laminate of a predetermined number of the prepregs.

Examples of a method of bonding each second insulating layer 51 to the first base member 4 include a vacuum pressing method, a laminating method, and the like. Among these methods, the vacuum pressing method is preferably used. This makes it possible to improve adhesion strength between the first base member 4 and the second insulating layer 51. In this regard, in order to improve adhesion between the first base member 4 and the second insulating layer 51, a surface of the first base member 4 may be subjected to a roughening treatment using an oxidant such as permanganate, dichromate or the like.

Next, the through-holes 53 are formed so as to pass through the second insulating layer 51 in the thickness direction thereof (see, FIG. 2(1e)). The through-holes 53 can be formed in the same manner as the through-holes 43.

Next, cylindrical conductor posts 6 are formed into the through-holes 53, respectively, and metal layers 52a are, respectively, formed onto surfaces of the second insulating layers 51 opposite to the first base member 4 (FIG. 2(1f)). Such meal layers 52a and conductor posts 6 can be formed in the same manner as the metal layers 42a and the conductor posts 6 described in the first base member 4.

Thereafter, each metal layer 52a is subjected to an etching treatment or the like to form the second conductor layer (circuit pattern) 52 (see, FIG. 2(1g)). In this way, the second base members 5A and 5B are obtained. Namely, the rigid portion 2 and the flexible portions 3 are formed, respectively. As a results, the multilayer wiring board 1 is obtained.

In this embodiment, a case that one second insulating layer 51 and one second conductor layer 52 are formed on both surfaces of the first base member 4, respectively, has been described. However, two or more second insulating layers 51 and two or more second conductor layers 52 may be formed on both surfaces of the first base member 4, respectively. A multilayer wiring board 1 having such a structure can be obtained by repeatedly carrying out the above steps (see, FIGs. 2(1d) to 2(1g)).

The multilayer wiring board 1 obtained in this way includes the second base member 5A provided with the second insulating layer 51 having the coefficient of thermal expansion set to the value within the above range on the outermost surface side thereof. Therefore, the multilayer wiring board 1 can have excellent semiconductor element mounting reliability. Further, in particular, in the case where the second insulating layer 51 has a sufficiently high glass-transition temperature, the multilayer wiring board 1 can have more excellent semiconductor element mounting reliability.

### <Semiconductor device>

Next, a semiconductor device 100 will be described.

As shown in FIG. 3, the semiconductor device 100 includes a semiconductor element 101 and the above-mentioned multilayer wiring board 1.

The semiconductor element 101 is mounted on an upper side (one surface side) of the multilayer wiring board 1 in FIG. 3 and electrically connected to predetermined portions of the second conductor layer 52 of the second base member 5A. Further, predetermined terminals provided in the semiconductor element 101 and predetermined terminals provided in the second conductor layer 52 are electrically connected to each other via bumps 102 made of solder.

The multilayer wiring board 1 includes the second insulating layers 51 each having sufficiently low coefficient of thermal expansion. Therefore, even in the case where the semiconductor element 101 is directly connected to the second conductor layer 52 without using an interposer or the like as described above, it is possible to prevent a bad connection or the like for a long period of time.
Namely, the semiconductor device 100 can appropriately operate for a long period of time, and thus it has high reliability. Further, since the semiconductor element 101 is connected to the second conductor layer 52 without using the interposes or the like, the semiconductor device 100 can have a thin thickness. As a result, the semiconductor device 100 can have superior placement flexibility.

### [Second embodiment]

Next, a second embodiment of the multilayer wiring board and the semiconductor device according to the present invention will be described.

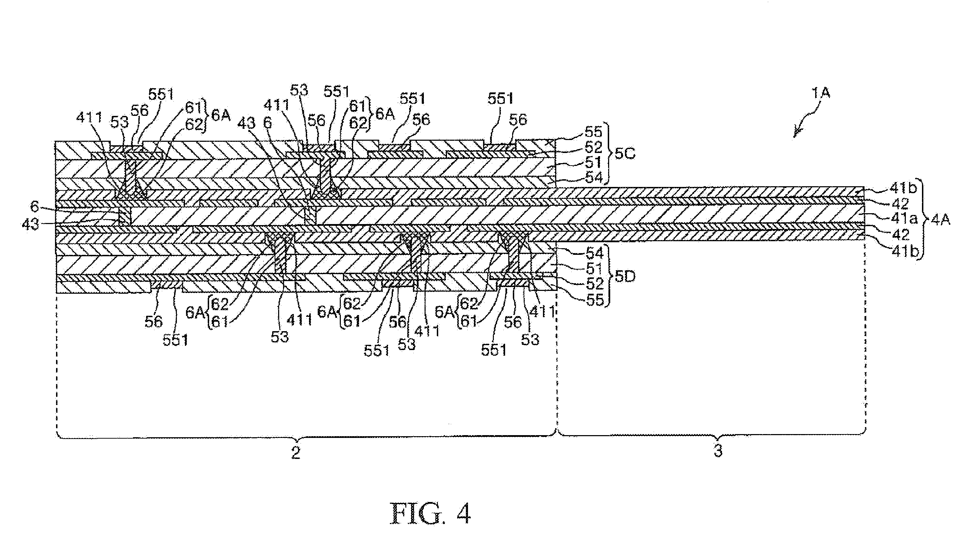

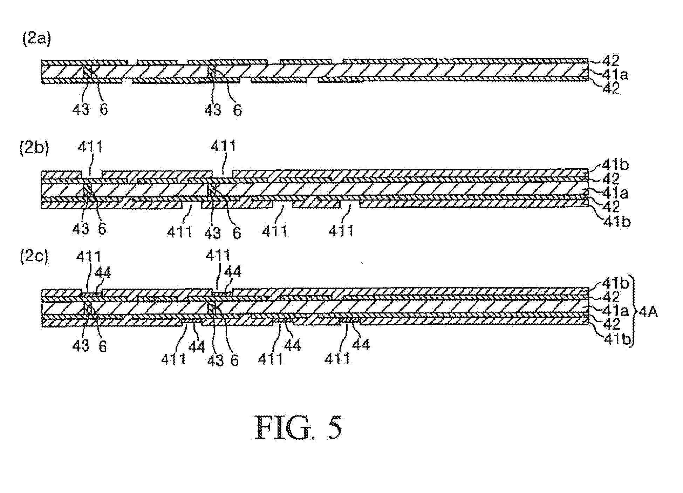

FIG. 4 is a longitudinal section showing a second embodiment of a multilayer wiring board according to the present invention, and each of FIGs. 5, 6 and 7 is a longitudinal section showing a preferred method of manufacturing the multilayer wiring board shown in FIG. 4.
Further, hereinbelow, an upper side of each of FIGs. 4 to 7 is referred to as "upper" or "upper side" and a lower side thereof is referred to as "lower" or "lower side" for convenience of explanation.

Hereinbelow, although the second embodiment will be described with reference to FIGs. 4 to 7, the following description will be focused on the points differing from the first embodiment, with the same points being omitted from the description.

A multilayer wiring board 1A includes a rigid portion 2 and a flexible portion 3 provided so as to be extended from the rigid portion 2.

The rigid portion 2 includes a first base member 4A having flexibility, a second base member 5C having high rigidity and provided on an upper surface of the first base member 4A and a second base member 5D having high rigidity and provided on a lower surface of the first base member 4A.

In the multilayer wiring board 1A, a layer structure of the rigid portion 2 and a structure of each conductor post 6A are mainly different from those in the first embodiment. Therefore, in this embodiment, the rigid portion 2 and each conductor post 6A will be described in detail.

The first base member 4A includes a first insulating layer 41a, first conductor layers 42 provided on both surfaces of the first insulating layer 41a and first insulating layers 41b each provided on a surface of the first conductor layer 42 opposite to the first insulating layer 41a. In other words, the first base member 4A is formed by laminating the first insulating layers 41b on both surfaces of the first base member 4 described in the above first embodiment.

In each first insulating layer 41b, opening portions 411 are formed so as to correspond to portions where the first conductor layer 42 and the second conductor layer 52 are to be electrically conducted to each other. In other words, the opening portions 411 are provided in each first insulating layer 41b so that the conductor posts 6 which will be described below can make contact with the first conductor layer 42.

Since structures of the second base member 5C and the second base member 5D are substantially identical to each other, the second base member 5C will be described representatively.

The second base member 5C includes a second insulating layer 51, a second conductor layer 52 provided on an upper surface of the second insulating layer 51, an adhesive layer 54 provided on a lower surface of the second insulting layer 51 and a surface coating layer 55 and brazing material layers 56 each provided on the second conductor layer 52.

The second insulating layer 51 and the second conductor layer 52 have the same structures as the above-mentioned first embodiment.

The surface coating layer 55 is provided on the second conductor layer 52. Since the multilayer wiring board 1A has such a surface coating layer 55, it is possible to prevent undesired contact of external products to the second conductor layer 52 or the like and an undesired electrical connection of external products to the second conductor layer 52. Further, the surface coating layer 55 also has a function of preventing peeling of the second conductor layer 52 from the second insulating layer 51 or the like.

Examples of a material constituting the surface coating layer 55 include, but are not particularly limited to, the constituent material of the second insulating layer 51 as described above, materials such as various kinds of resins each having an insulating property.

Further, opening portions 551 are provided in the surface coating layer 55. The opening portions 551 are formed so as to correspond to terminals of a semiconductor element to be mounted on the multilayer wiring board 1A, so that the second conductor layer 52 and the terminals of the semiconductor element can be connected to each other.

Further, the brazing material, layers 56 are provided on the second conductor layer 52 exposing inside the opening portions 551. In such a structure, when the semiconductor element (electronic part) is mounted on the multilayer wiring board 1A, the terminals of the semiconductor element can be firmly fixed to the second conductor layer 52 via the brazing material layers 56 existing within the opening portions 551.

A constituent material of the brazing material layers 56 is not limited to a specific type. As the constituent material of the brazing material layers 56, various kinds of brazing materials (solders) such as a tin-lead type alloy, a tin-silver type alloy, a tin-zinc type alloy, a tin-bismuth type alloy, a tin-antimony type alloy, a tin-silver-bismuth type alloy, a tin-copper type alloy can be used.

The adhesive layer 54 is provided on a surface of the second insulating layer 51 opposite to the surface coating layer 55, and has a function of bonding the second insulating layer 51 and the first insulating layer 41 b to each other.

A material constituting the adhesive layer 54 is not limited to a specific type, as long as it has an insulating property and functions as an adhesive. As the material constituting the adhesive layer 54, for example, an adhesive having a flux function can be used. Here, the flux function means a function of removing or reducing an oxide film formed on a metal surface.
In the case where the adhesive layer 54 has such a flux function, it is possible to reliably prevent oxidation of a surface of a metal coating layer 62 of each conductor post 6A which will be described below when manufacturing the multilayer wiring board 1A using a method as described below. Therefore, the metal coating layers 62 can be bonded to the first conductor layer 42 reliably.

Such an adhesive having the flux function includes a resin having a phenolic hydroxyl group (A) such as phenol novolak resin, cresol novorak resign, alkyl phenol novorak resign, resole resin or polyvinyl phenolic resin, and a curing agent for the resin (A).
Examples of the curing agent (B) include an epoxy resin in which a phenol base such as a bisphenol type base, a phenol novolak type base, an alkyl phenol novolak type base, a biphenol type base, a naphthol type base or a resorcinol type base is epoxidized, an epoxy resin in which a base including a chemical structure such as an aliphatic chemical structure, a cyclic aliphatic chemical structure or an unsaturation aliphatic chemical structure is epoxidized, an isocyanate compound, and the like.

Further, in the second base member 5C, through-holes 53 are formed in the same manner as the above-mentioned first embodiment.

Furthermore, the conductor posts 6A are provided inside the through-holes 53 of the second base member 5C. Each conductor post 6A is constituted from a protruding terminal 61 and a metal coating layer 62.

The protruding terminal 61 of each conductor post 6A is provided inside the through-hole 53 of the second base member 5C. Further, one end of the protruding terminal 61 makes contact with the second conductor layer 52 so that it is electrically connected to the second conductor layer 52. On the other hand, the other end of the protruding terminal 61 is protruded from the second insulating layer 51.

A constituent material of the protruding terminal 61 is not limited to a specific type, as long as it has conductivity. Examples of the constituent material of the protruding terminal 61 include various kinds of mentals and various kinds of alloys such as copper, a copper type alloy, aluminum and an aluminum type alloy.

The metal coating layer 62 is provided around the other end of the protruding terminal 61 protruded from the second insulating layer 51. Further, the metal coating layer 62 makes contact with the first conductor layer 42 so that it is electrically connected to the first conductor layer 42. In the case where each conductor post 6A has such a metal coating layer 62, it is possible to electrically connect the protruding terminal 61 and the first conductor layer 42 to each other reliably. Namely, it is possible to electrically connect the first conductor layer 42 and the second conductor layer 52 to each other via the conductor posts 6A reliably.
Further, even in the case where temperature change of the surrounding environment occurs or external force is imparted to the multilayer wiring board 1A from the outside thereof, it is possible to reliably maintain a state that the protruding terminals 61 and the first conductor layer 42 are electrically connected to each other via the metal coating layers 62. As a result, when the multilayer wiring board 1A on which electronic parts or the like are mounted is used, it hardly breaks down and can exhibit more excellent reliability.

As a constituent material of the metal coating layer 62, for example, the above-mentioned brazing materials (solders) can be used. This makes it possible to sufficiently bond the metal coating layer 62 and the first conductor layer 42 to each other. In addition, the protruding terminals 61 can be firmly fixed to the first conductor layer 42 by the metal coating layers 62. Further, by using a method which will be described below, it is possible to manufacture a multilayer wiring board 1A easily and reliably.

The metal coating layers 62 of the conductor posts 6A are provided so as to coat the first conductor layer 42 exposing inside the opening portions 411 of the first insulating layer 41b. In such a structure, even in the case where external force is imparted to the multilayer wiring board 1A from the outside thereof, it is possible to more reliably maintain a state that the metal coating layers 62 and the first conductor layer 42 are bonded to each other.

The flexible portion 3 is constituted from the first base member 4A continuously extended from the rigid portion 2.

For example, the multilayer wiring board 1A as described above can be manufactured as follows.

A method of manufacturing the multilayer wiring board 1A include a first base member production step in which the first base member 4A is produced, a second base member production step in which the second base members 5C and 5D, and a lamination step in which the first base member 4A and the second base members 5C and 5D are laminated to each other.

### (First base member production step)

First, the first insulating layer 41a is prepared, and then the conductor posts 6 are formed in the first insulating layer 41a. Further, the first conductor layers 42 are formed on both surfaces of the first insulating layer 41a (see, FIG. 5(2a)). These formation methods are the same as those in the production method of the first base member 4 of the above-mentioned first embodiment.

Next, the first insulating layers 41 b are formed on the first conductor layers 42 (see, FIG. 5(2b)). Each first insulating layer 41 b can be formed by, for example, using a method in which a film which becomes to the first insulating layer 41 b attaches to the first conductor layer 42.

The opening portions 411 of each first insulating layer 41b may be formed using the laser as described above. Further, the opening portions 411 also may be formed at the same time when each first insulating layer 41b is formed by attaching the film to the first conductor layer 42.

Next, brazing material layers 44 are formed on each first conductor layer 42 exposing inside the opening portions 411 (see, FIG. 5(2c)). In this way, the first base member 4A is obtained.

Each brazing material layer 44 can be formed by, for example, melting a brazing material and then applying the molten brazing material onto each first conductor layer 42 exposing inside the opening portions 411.

Each brazing material layer 44 constitutes a part of the metal coating layer 62 of each conductor post 6A as described above. In, this way, in the case where the brazing material layers 44 have, in advance, been formed on the first conductor layer 42, it is possible to more easily bond the metal coating layers 62 to the first conductor layer 42 in the multilayer wiring board 1A.

### (Second base member production step)

Aside from the first base member 4A, the second base members 5C and 5D are produced. A method of producing the second base member 5C is the same as a method of producing the second base member 5D. Therefore, representatively, the method of producing the second base member 5C will be described below.

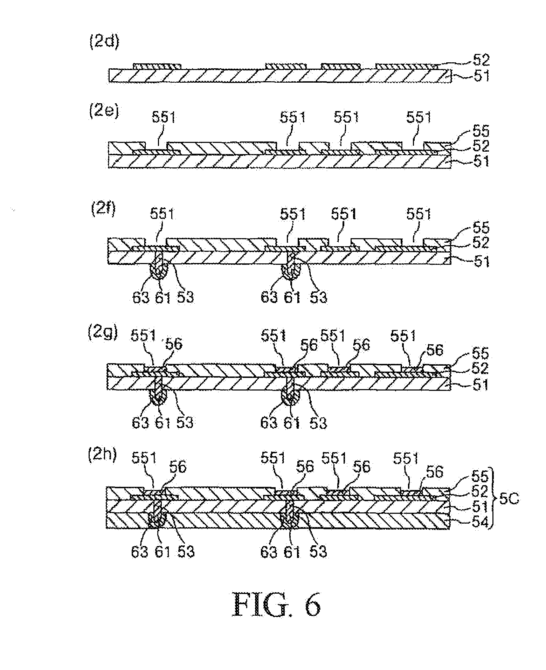

First, the second insulating layer 51 is prepared, and then the second conductor layer 52 is formed on the second insulating layer 51 (see, FIG. 6(2d)). The second conductor layer 52 can be formed in the same manner as the second conductor layer 52 of the above-mentioned first embodiment.

Next, the surface coating layer 55 with the opening portions 551 is formed on the second conductor layer 52 (see, FIG. 6(2e)).

The surface coating layer 55 can be formed by, for example, using a method in which a film which becomes to the surface coating layer 55 attaches to the second conductor layer 52, or a method in which ink containing a material for constituting the surface coating layer 55 is applied onto the second conductor layer 52.

The opening portions 551 of the surface coating layer 55 may be formed using the laser as described above. Further, the opening portions 551 also may be formed at the same time when the surface coating layer 55 is formed by attaching the film to the second conductor layer 52, applying the ink onto the second conductor layer 52 using a printing or the like.

Next, the through-holes 53 are formed so as to pass through the second insulating layer 51 in the thickness direction thereof, the protruding terminals 61 are provided inside the through-holes 53, and then surfaces, of the protruding terminals 61 are coated with metal coating films 63 (see, FIG. 6(2f)). In this way, the conductor posts 6A are formed.

The protruding terminal 61 of each conductor post 6A can be formed by, for example, applying a paste containing a conductor material or carrying out a metal plating.

Each metal coating film 63 can be formed by, for example, melting a brazing material and then coating the other end of the protruding terminal 61 with the molten brazing material.

Next, the brazing material layers 56 are formed on the second conductor layer 52 exposing inside the opening portions 551 (see, FIG. 6(2g)).

The brazing material layers 56 can be formed in the same manner as the above-mentioned brazing material layers 44.

Next, the adhesive layer 54 is formed on a surface of the second insulating layer 51 opposite to the second conductor layer 52 (see, FIG. 6(2h)). In this way, the second base member 5C is obtained.

The adhesive layer 54 can be formed using, for example, a method in which an adhesive agent is applied to the surface of the second insulating layer 51 or a method in which a sheet-shaped adhesive agent attaches to the surface of the second insulating layer 51.

### (Lamination step)

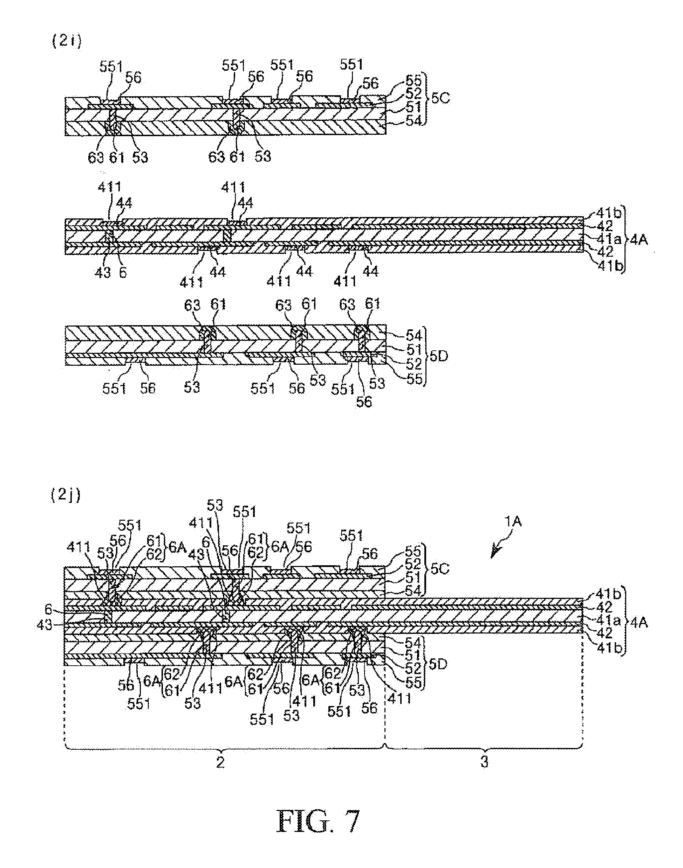

Finally, the first base member 4A and the second base members 5C and 5D each obtained through the above-mentioned step are laminated to each other so that the multilayer wiring board 1A including the rigid portion 2 and the flexible portion 3 is obtained (see, FIGs. 7(2i) and 7(2j)).

Lamination of the second base member 5C (5D) on the first base member 4A is carried out by positioning the second base member 5C (5D) to the first base member 4A so that the metal coating films 63 of the second base member 5C (5D) make contact with the corresponding brazing material layers 44 inside the opening portion 411 of the first base member 4A, and then pressing them with being heated.
By applying the heat in this way, the brazing material layers 56 and the metal coating films 63 are melted to firmly bond them to each other. As a result, the metal coating layers 62 are formed so that the conductor posts 6A are obtained.

Hereinabove, the preferred embodiments of the multilayer wiring board of the present invention have been described, but the multilayer wiring board of the present invention is not limited thereto.

In each of the above-mentioned embodiments, the rigid portion includes one first insulating layer or three first insulating layers, but is not limited thereto. For example, the rigid portion may include two first insulating layers or four or more first insulating layers.
In particular, it is preferred that the multilayer wiring board includes one to four first insulating layers. This makes it possible to impart more excellent flexibility to the first base member 4 while maintaining sufficiently high tensile modulus (flexural rigidity) of the rigid portion 2. As a result, the multilayer wiring board can have a flexible portion having more excellent flexibility, to thereby exhibit more superior placement flexibility.

Further, in each of the above-mentioned embodiments, the rigid portion includes two second insulating layers, but is not limited thereto, For example, the rigid portion may include one second insulating layer or three or more second insulating layers.
In particular, it is preferred that the multilayer wiring board includes two to ten second insulating layers. This makes it possible to impart sufficiently high tensile modulus (rigidity) to the rigid portion, thereby improving semiconductor element mounting reliability. Further, the rigid portion can be formed so as to have a thin thickness so that the multilayer wiring board can have more superior placement flexibility.

In each of the above-mentioned embodiments, the first base member include two first conductor layers, but is not limited thereto. For example, the first base member may include one first conductor layer or three or more first conductor layers.

Further, in each of the above-mentioned embodiments, each second base member includes one second conductor layer, but is not limited thereto. For example, each second base member may include a plurality of second conductor layers.

In each of the above-mentioned embodiments, an end portion of the flexible portion opposite to the rigid portion has been connected to electronics such as other circuit boards, but is not limited thereto. The end portion of the flexible portion opposite to the rigid portion may be adapted to be connected to electronics such as other circuit boards.

Further, in each of the above-mentioned embodiments, the multilayer wiring board includes one rigid portion, but is not limited thereto. For example, the multilayer wiring board may include a plurality of rigid portions.

In the above-mentioned embodiment shown in FIG. 3, the semiconductor element is connected to the multilayer wiring board via only the bumps, but may be connected to (mounted on) the multilayer wiring board via a transfer substrate (interposer substrate) or the like.

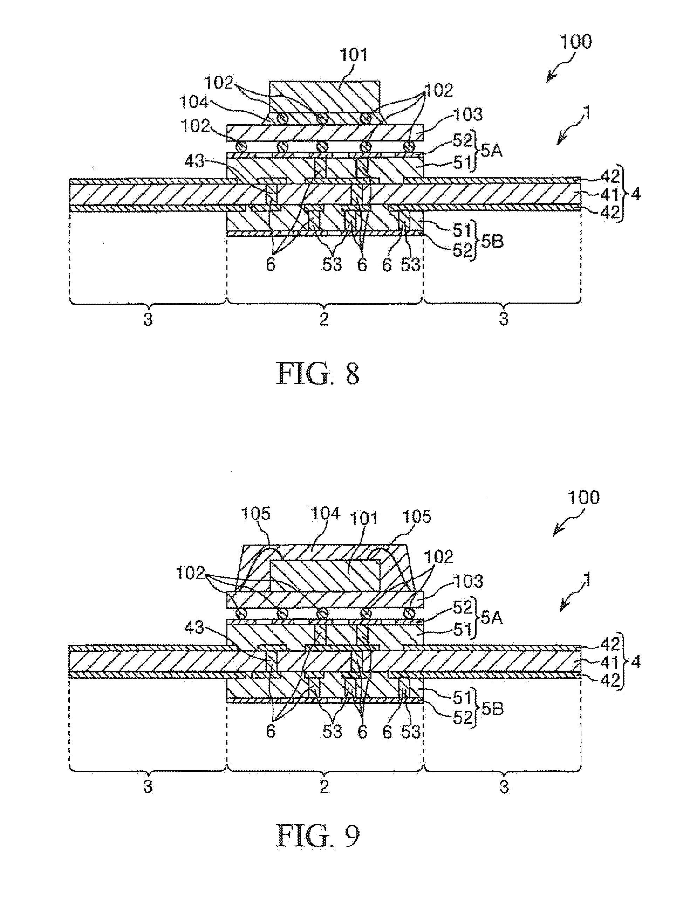

Specifically, in a structure shown in FIG. 8, a plurality of bumps 102 are provided on the second conductor layer 52 of the multilayer wiring board 1, and a transfer substrate 103 is disposed on the bumps 102. As a result, the second conductor layer 52 and the transfer substrate 103 are electrically connected to each other via the bumps 102.

Further, a plurality of bumps 102 are also provided on the transfer substrate 103, and a semiconductor element 101 is disposed on these bumps 102. As a result, the transfer substrate 103 and the semiconductor element 101 are electrically connected to each other via the bumps 102. In such a structure, the second conductor layer 52 and the semiconductor element 101 are electrically connected to each other.

Furthermore, a well-known encapsulating material (underfill) 104 fills between the transfer substrate 103 and the semiconductor element 101 so that the bumps 102 are sealed. This makes it possible to more reliably electrically connect the transfer substrate 103 and the semiconductor element 101 to each other via the bumps 102.

In another structure shown in FIG. 9, a plurality of bumps 102 are provided on the second conductor layer 52 of the multilayer wiring board 1, and a transfer substrate 103 is disposed on the bumps 102. As a result, the second conductor layer 52 and the transfer substrate 103 are electrically connected to each other via the bumps 102.

Further, a semiconductor element 101 is also provided on the transfer substrate 103, and wirings 105 are formed so as to connect an upper surface of the semiconductor element 101 to an upper surface of the transfer substrate 103. Each wiring 105 is formed of a metal such as gold using a plating or the like. The transfer substrate 103 and the semiconductor element 101 are electrically connected to each other via these wirings 105.

Furthermore, the semiconductor element 101 and the wirings 105 are sealed with a well-known encapsulating material (underfill) 104. This encapsulating material makes it possible to more reliably electrically connect the transfer substrate 103 and the semiconductor element 101 to each other.

As described above, even in the case where the semiconductor element is mounted on the multilayer wiring board via the above-mentioned transfer substrate, the multilayer wiring board can exhibit excellent semiconductor element mounting reliability.

### Examples

Hereinbelow, the present invention will be described in detail based on the following Examples and Comparative Examples, but is not limited to these Examples.

### [1] Manufacture of multilayer wiring board and semiconductor device

Multilayer wiring boards and semiconductor devices were, respectively, manufactured. In this regard, each multilayer wiring board and each semiconductor device were, respectively, manufactured as follows.

### (Example 1)

### [1-1] Preparation of resin varnish

Predetermined amounts of a prepolymer of a resin material, an inorganic filler and a coupling agent each described below were added to methyl ethyl ketone as an organic solvent so that an amount of a solid content become 50 wt%. Thereafter, they were stirred using a high speed stirring machine for 10 minutes. In this way, a resin varnish in which the prepolymer of the resin material and the inorganic filler were dispersed and/or dissolved into the organic solvent was prepared.

As a prepolymer of cyanate resin, novolak type cyanate resin having a weight average molecular weight of about 2,600 ("Primaset PT-60" produced by LONZA Japan): 30 parts by weight, and novolak type cyanate resin having a weight average molecular weight of about 700 ("Primaset PT-30" produced by LONZA Japan): 10 parts by weight were used.
As a prepolymer of epoxy resin, biphenyl dimethylene type epoxy resin having an epoxy equivalent of 275 g/eq ("NC-3000" produced by Nippon Kayaku Co., Lid.): 8 parts by weight was used.
As a prepolymer of phenolic resin, biphenyl alkylene type novolak resin having an hydroxyl equivalent of 203 ("MEH-7851-S" produced by Meiwa Plastic Industries, Ltd.): 5 parts by weight, and phenol novolak resin having a hydroxyl equivalent of 103 g/eq and a weight-average molecular weight of about 1,600 ("PR-51714" produced by Sumitomo Bakelite Co., Ltd.): 2 parts by weight were used.
As the inorganic filler, spherical fused silica having an average particle size of 0.5 µm ("SO-25R" produced by Admatechs Co., Ltd.): 40 parts by weight, and spherical fused silica having an average particle size of 0.3 µm ("SFP-10X" produced by Denki Kagaku Kogyo K.K.): 5 parts by weight were used.
As the coupling agent, an epoxy silane type coupling agent ("A-187" produced by Nippon Unicar Company Limited): 0.3 part by weight was used.

### [1-2] Production of prepreg

The above-mentioned resin varnish was impregnated into a glass woven cloth having a thickness of 28 µm ("WEA-1035" produced by Nitto Boseki Co., Ltd.), and dried at 120°C for 2 minutes using a furnace. In this way, a prepreg including a varnish solid content (that is, the resin material and the silica contained in the prepreg) in an amount of about 50 wt% was obtained.

### [1-3] Manufacture of multilayer wiring board

A first laminated body (two-layer double-sided copper-clad laminated board) in which copper foils (metal layers) each having a thickness of 18 µm attached on both surfaces of a polyimide film (first insulating layer) having a thickness of 25 µm ("ESPANEX SB-18-25-18FR" produced by Nippon Steel Chemical Co., Ltd.) was prepared.
This first laminated body was subjected to an etching so as to leave a predetermined portion of the metal layers to thereby form first conductor layers (conductor circuits). A ratio of an area of each first conductor layer with respect to an area of the first insulating layer in a planar view thereof was 50%.
Next, through-holes were formed at predetermined portions of the first laminated body using a drill, and conductor posts were provided inside the through-holes by carrying out a plating treatment using copper as a material thereof. In this way, a first base member was obtained.

Subsequently, a predetermined number of the prepregs as described above were laminated on both surfaces of the first base member, respectively, and then they were heated and pressed at a pressure of 4 MPa, at a temperature of 200°C for 2 hours. In this way, a second laminated body in which second insulating layers were laminated on both surfaces of the first base member was obtained. In this regard, it is to be noted that each second insulating layer had a thickness of 80 µm.

Next, predetermined portions of each second insulating lawyer of the second laminated body were irradiated with laser to form through-holes, a surface of each second insulating layer was subjected to a plating to form a plating layer, and then the plating layer was etched. In this way, a second conductor layer was formed on each second insulating layer.
At the same time, conductor posts through which the second conductor layer and the first conductor layer were electrically connected to each other were formed. In this regard, it is to be noted that a ratio of an area of the second conductor layer with respect to an area of the second insulating layer in a planar view thereof was 50%.
In other words, as shown in FIG. 1, a multilayer wiring board (double-sided copper-clad laminated board) including a rigid portion and flexible portions was obtained. In this regard, it is to be noted that each formed second conductor layer had a thickness of 18 µm.

### [1-4] Manufacture of semiconductor device (mounting of semiconductor element)

Bumps made of lead-free solder (composition: Sn-3.5Ag, melting point: 221°C, coefficient of thermal expansion: 22 ppm/°C, tensile modulus: 44 GPa) were positioned and applied on the manufactured multilayer wiring board using a flip chip bonder, and then a semiconductor element having a size of 7 mm square and 192 terminals was temporarily bonded to the bumps.
Thereafter, they were subjected to an IR reflow by being passed through a reflow furnace under reflow conditions that a maximum temperature was 260°C, a minimum temperature was 183°C and a time was 60 seconds so that the bumps and the terminals were bonded to each other. In this way, a semiconductor device (evaluation package) as shown in FIG. 3 was obtained.

### [1-5] Production of second base member (for evaluation)

In order to evaluate a coefficient of thermal expansion and a glass-transition temperature of a second insulating layer, and a storage modulus of a second base member, evaluation second base members were produced. In this regard, each evaluation second base member was produced as follows.

A predetermined number of prepregs obtained in the same manner as described above were laminated on each other, and copper foils each having a thickness of 18 µm were laminated on outsides of the prepregs. Thereafter, they were heated and pressed at a pressure of 4 MPa, at a temperature of 200°C for 2 hours. In this way, the evaluation second base member (double-sided copper-clad laminated board) was produced.

In this regard, it is to be noted that an evaluation second base member having a thickness of 0.8 mm and an evaluation second base member having a thickness of 1.6 mm were produced.

### (Example 2)

Semiconductor devices and evaluation second base members were, respectively, manufactured in the same manner as in Example 1, except that the composition of the resin varnish was changed as shown in Table 1.

### (Example 3)

Multilayer wiring boards and semiconductor devices were, respectively, manufactured. In this regard, each multilayer wiring board and each semiconductor device were, respectively, manufactured as follows.

### [First base member production step]

A first laminated body (two-layer double-sided copper-clad laminated board) in which copper foils (metal layers) each having a thickness of 18 µm attached on both surfaces of a polyimide film (first insulating layer) having a thickness of 25 µm ("ESPANEX SB-18-25-18FR" produced by Nippon Steel Chemical Co., Ltd.) was prepared.
This first laminated body was subjected to an etching so as to leave a predetermined portion of the metal layers to thereby form first conductor layers (conductor circuits). A ratio of an area of each first conductor layer with respect to an area of the first insulating layer in a planar view thereof was 50%.
Next, through-holes were formed at predetermined portions of the first laminated body using a drill, and conductor posts were provided inside the through-holes by carrying out a plating treatment using copper as a material thereof.

Subsequently, thermosetting adhesive agent films attached on both surfaces of the first laminated body so that a thickness of each thermosetting adhesive agent film became 25 µm, and a polyimide film having a thickness of 25 µm ("APICAL NPI" produced by Kanegafuchi Chemical Ind. Co., Ltd.) was laminated on each thermosetting adhesive agent film. In this way, first insulating layers were formed to thereby obtain a second laminated body.
Next, the first insulating layers existing on both surface sides of the second laminated body were irradiated with CO₂ laser to form opening portions, and then the first insulating layers were subjected to a besmear.

Thereafter, solder plating layers each having a thickness of 30 µm as brazing material layers were formed on each first conductor layer exposing inside the opening portions, to thereby obtain a first base member including three first insulating layers as shown in FIG. 7 (2i).

### [Second base member production step]

A predetermined number of prepregs obtained in the same manner as in Example 1 were laminated on each other, and heated and pressed at a pressure of 4 MPa, at a temperature of 200°C for 2 hours. In this way, a second insulating layer having a thickness of 80 µm was obtained.

A copper layer having a thickness of 12 µm was formed on one major surface of the second insulating layer using a plating, and then the copper layer was etched to thereby form a second conductor layer (conductor circuit). In this regard, it is to be noted that a ratio of an area of the second conductor layer with respect to an area of the major surface of the second insulating layer in a planar view thereof was 50%.

Next, a surface coating layer having a thickness of 20 µm was formed on the second insulating layer by printing a liquid resist ("SR900W" produced by Hitachi Chemical Co., Ltd.) thereonto. In this regard, it is to be noted that the surface coating layer was provided so as to form opening portions inside which predetermined portions of the second conductor layer were exposed.

Next, the other major surface of the second insulating layer opposite to the second conductor layer was irradiated with CO₂ laser to form through-holes each having a diameter of 100 µm, and then the second insulating layer was subjected to a desmear using a potassium permanganate aqueous solution.

Protruding terminals each having a height of 100 µm were formed inside the through-holes by carrying out an electrolytic copper plating. One end of each protruding terminal was protruded from the other major surface of the second insulating layer opposite to the second conductor layer. On the other hand, the other end of each protruding terminal made contact with the second conductor layer.
A metal coating film having a thickness of 10 µm was formed on a portion of each protruding terminal protruded from the second insulting layer by carrying out a solder plating.

Bumps made of lead-free solder (composition: Sn-3.5Ag, melting point: 221°C, coefficient of thermal expansion: 22 ppm/°C, tensile modulus: 44 GPa) were applied on the second conductor layer exposing inside the opening portions of the surface coating layer using a flip chip bonder.

Next, a thermosetting adhesive agent sheet with a flux function having a thickness of 20 µm ("Adhesive sheet RCF" produced by Sumitomo Bakelite Co., Ltd.) was laminated on the other major surface from which the protruding terminals were protruded, to thereby form an adhesive layer.

By repeating the above-mentioned operation two times, two second base members as shown in FIG. 7 (2i) were produced.

### [Manufacture of multilayer wiring board]

The two obtained second base members were laid-up (laminated) on both surfaces of the first base member using a jig having pin guides for positioning, to thereby form a laminated body. At this time, they were laminated on each other so that the brazing material layers of the first base member corresponded to the protruding terminals of the second insulating layer.
Thereafter, this laminated body was subjected to a preliminary bonding treatment using a vacuum pressure laminator under conditions that a temperature was 130°C and a pressure was 0.6 MPa for 30 seconds, and then subjected to a press treatment using a hydraulic press machine under conditions that a temperature was 250°C and a pressure was 1.0 MPa for 30 minutes.
In this way, the metal coating film of each conductor post and solder contained in each brazing material layer provided in the first base member were melted and bonded to each other, to thereby form a metal coating layer through which the first conductor layer and the second conductor layer were electrically connected to each other.

Next, this laminated body was heated under conditions that a temperature was 150°C and a pressure was 2 MPa for 60 minutes, to thereby cure the adhesive layer. In this way, as shown in FIG. 4, a Multilayer wiring board including a rigid portion and a flexible portion was obtained.

Hereinbelow, semiconductor devices and evaluation second base members were, respectively, manufactured in the same manner as in Example 1.

### (Comparative Example 1)

Semiconductor device and evaluation second base members were, respectively, manufactured in the same manner as in Example 1, except that the composition of the resin varnish was changed as shown in Table 1.

### (Comparative Example 2)

Semiconductor device and evaluation second base members were, respectively, manufactured in the same manner as in Example 1, except that the composition of the resin varnish was changed as shown in Table 1.

### (Comparative Example 3)

Semiconductor device and evaluation second base members were, respectively, manufactured in the same manner as in Example 1, except that polyimide films each having a thickness of 80 µm ("APICAL NPI" produced by Kanegafuchi Chemical Ind. Co., Ltd.) were used instead of the prepregs.
The second base members of each semiconductor device and the evaluation second base members obtained in this way had flexibility. Namely, each semiconductor device had a flexible printed board as the multilayer wiring board.

In Table 1, the composition of the resin varnish and the composition of the second insulating layer used in each of Examples and Comparative Examples are indicated.
In Table 1, "Silica A" indicates the spherical fused silica having the average particle size of 0.5 µm ("SO-25R" produced by Admatechs Co., Ltd.), "Silica B" indicates the spherical fused silica having the average particle size of 0.3 µm ("SFP-10X" produced by Denki Kagaku Kogyo K.K.), and "coupling agent" indicates the epoxy silage type coupling agent ("A-187" produced by Nippon Unicar Company Limited), respectively.
Further, in Table 1. "Cyanate resin A" indicates the novolak type cyanate resin having the weight-average molecular weight of about 2,600 ("Primaset PT-60" produced by LONZA Japan), "Cyanate resin B" indicates the novolak type cyanate resin having the weight-average molecular weight of about 700 ("Primaset PT-30" produced by LONZA Japan), and "Epoxy resin" includes the biphenyl dimethylene type epoxy resin having the epoxy equivalent of 275 g/eq ("NC-3000" produced by Nippon Kayaku Co., Ltd.), respectively.
Furthermore, in Table 1, Phenolic resin A" indicates the biphenyl alkylene type novolak resin having the hydroxyl equivalent of 203 ("MEH-7851-S" produced by Meiwa Plastic Industries, Ltd.), and "Phenolic resin B" indicates the phenol novolak resin having the hydroxyl equivalent of 103 g/eq and the weight-average molecular weight of about 1,600 ("PR-51714" produced by Sumitomo Bakelite Co., Ltd.), respectively.

**Table 1**

| | | Unit | Ex. 1 | Ex. 2 | Ex. 3 | Com. Ex. 1 | Com. Ex. 2 | Com. Ex. 3 |
|---|---|---|---|---|---|---|---|---|
| Composition of resin varnish | Silica A | [Parts by weight] | 40 | 45 | 40 | 60 | - | - |
| | Silica B | | 5 | - | 5 | - | - | - |
| | Coupling agent | | 0.3 | 0.3 | 0.3 | 0.3 | - | - |
| | Cyanate resin A | | 30 | 40 | 30 | - | 50 | - |
| | Cyanate resin B | | 10 | - | 10 | - | - | - |
| | Epoxy resin | | 8 | 8 | 8 | 22.5 | 28 | - |
| | Phenolic resin A | | 5 | 7 | 5 | 17.5 | 22 | - |
| | Phenolic resin B | | 2 | - | 2 | - | - | - |
| Composition of second insulating layer | Amount of resin material contained in second insulating layer: S | [wt%] | 27.5 | 27.5 | 27.5 | 20 | 50 | - |
| | Amount of core material contained in second insulating layer: T | | 50 | 50 | 50 | 50 | 50 | - |
| | Amount of inorganic filler contained in second insulating layer: U | | 22.5 | 22.5 | 22.5 | 30 | - | - |
| | T/S | [wt%/wt%] | 1.8 | 1.8 | 1.8 | 2.5 | 1.0 | - |
| | U/S | | 0.82 | 0.82 | 0.82 | 1.50 | - | - |
| | Phenolic resin/ Cyanate resin | | 0.18 | 0.18 | 0.18 | - | - | - |
| | Epoxy resin/ Cyanate resin | | 0.20 | 0.20 | 0.20 | - | - | - |

### [2] Physical property measurement and evaluation

On the semiconductor devices and the evaluation second base members obtained in each of Examples and Comparative Examples, the following physical property measurement and evaluation were curried out.

### [2-1] Coefficient of thermal expansion

The evaluation second base member having the thickness of 1.6 mm was etched as a whole to obtain a laminated board (second insulating layer), and then a test piece having a size of 2 mm × 2 mm was cut off from the laminated board. Thereafter, coefficients of thermal expansion of the test piece in thickness and plane directions thereof were measured using a TMA method (thermal mechanical analysis method) at a temperature rising rate of 5°C/min.
In this regard, it is to be noted that a measured temperature range of the coefficient of thermal expansion was set to a range of 20°C to a glass-transition temperature of the second insulating layer.

### [2-2] Glass-transition temperature

The evaluation second base member having the thickness of 0.8 mm was etched as a whole to obtain a laminated board (second insulating layer), and then a test piece having a size of 10 mm × 60 mm was cut off from the laminated board. Thereafter, a tensile modulus of the test piece was measured using a dynamic viscoelasticity measuring apparatus ("DMA 983" produced by TA Instrument) at a temperature rising rate of 3°C/min. A glass-transition temperature was defined as a peak value of tan δ.

### [2-3] Tensile modulus

The evaluation second base member having the thickness of 0.8 mm was etched as a whole to obtain a laminated board (second insulating layer), and then a test piece having a size of 10 mm × 60 mm was cut off from the laminated board. Hereafter, a tensile modulus of the test piece was measured using a dynamic viscoelasticity measuring apparatus ("DMA 983" produced by TA Instrument) at a temperature rising rate of 3°C/min. In this way, values of the tensile modulus were obtained in the respective temperature environment,

### [2-4] Mounting reliability test

10 semiconductor devices (evaluation packages) obtained in each of Examples and Comparative Examples were subjected to a thermal cycle test. By using this thermal cycle test, it was confirmed whether or not the bumps made of the lead-free solder were protected. Thereafter, a comparative evaluation of the results confirmed in the semiconductor devices of Examples and Comparative Examples was carried out.
Specifically, in the thermal cycle test, each semiconductor device was treated by repeating 500 thermal cycles each consisting of cooling at -55°C and heating at 125°C, and then was subjected to an electrical connection test. As a result, a semiconductor device in which all bumps exhibited electrical connections was defined as a good-quality package, and the number of the good-quality package was counted.
Thereafter, the number of the bad-quality package with respect to a total number of the semiconductor devices used for carrying out the thermal cycle test (10 semiconductor devices) was calculated, and this value was used as an index for indicating semiconductor element mounting reliability.

In Table 2, these evaluations and the measurement results are shown.

**Table 2**

| | | Unit | Ex. 1 | Ex. 2 | Ex. 3 | Com. Ex. 1 | Com. Ex. 2 | Com. Ex. 3 |
|---|---|---|---|---|---|---|---|---|
| Second insulating layer | Coefficient of thermal expansion in plane direction | [ppm/°C] | 11 | 12 | 11 | 14 | 16 | - |
| | Coefficient of thermal expansion in thickness direction | | 16 | 20 | 16 | 30 | 50 | - |
| | Glass-transition temperature | [°C] | 240 | 250 | 240 | 150 | 200 | - |
| First base member | Average thickness X | [µm] | 61 | 61 | 161 | 61 | 61 | 61 |
| Second base member | Average thickness Y | [µm] | 98 | 98 | 132 | 98 | 98 | 98 |
| | Tensile modulus Z | [GPa] | 20 | 20 | 20 | 11 | 8 | - |
| Y/X | | [µm/µm] | 1.61 | 1.61 | 0.82 | 1.61 | 1.61 | - |
| Y·Z | | [µm·GPa] | 1960 | 1960 | 2640 | 1078 | 784 | - |
| Mounting reliability test Bad-quality packages/semiconductor devices | | [Number/Number] | 0/10 | 0/10 | 0/10 | 3/10 | 6/10 | 10/10 |

As shown in Table 2, in the semiconductor devices obtained using the multilayer wiring boards (printed circuit boards) manufactured in each of Examples, defective electrical connections did not occur in the thermal cycle test (mounting reliability test). In contrast, in the semiconductor devices obtained using the multilayer wiring boards manufactured in each of Comparative Examples, defective electrical connections occurred in the thermal cycle test.
In particular, in all semiconductor devices obtained in Comparative Example 3, the defective electrical connections occurred. When bonded portions, which were formed by the bumps made of the lead-free solder and exhibited the defective electrical connections, were cut and cross sections thereof were checked, cracks were observed in all bonded portions.
This result indicates that, in order to prevent occurrence of cracks in bonded portions when subjecting a semiconductor device having a structure in which a flexible polyimide layer is used as the first insulating layer to the thermal cycle test, it is important to use a second insulating layer having sufficiently low coefficients of thermal expansion in thickness and plane directions at a surface portion of a multilayer wiring board.
Namely, this result indicates that, by setting the coefficients of thermal expansion of the second insulating layer in the thickness and plane directions thereof to low values, it is possible to suppress stress which would be generated in the bonded portions (bumps made of lead-free solder) due to a difference between a coefficient of thermal expansion of a Semiconductor element and that of a surface portion of the multilayer wiring board (printed circuit board), thereby preventing the occurrence of cracks in the bonded portions.
Further, each second insulating layer in Examples had a relatively high glass-transition temperature. Therefore, it is conceived that low coefficients of thermal expansion of the second insulating layer in the thickness and plane directions thereof were maintained even under a relatively high temperature environment by preventing extreme change of a physical property thereof.

Further, the semiconductor devices obtained in each of Comparative Examples 1 and 2 were cut after being subjected to the thermal cycle test, and cross sections thereof were checked. As a result, peeling between the second insulating layer and the second conductor layer was observed in each cross section.
On the other hand, when cross sections of the semiconductor devices obtained in each of Examples were checked, such a peeling between the second insulating layer and the second conductor laser was not observed in each cross section.
These results indicate that it is possible to appropriately prevent the occurrence of the peeling between the second insulating layer and the second conductor layer which is a conductor circuit by forming the second insulating layer so as to contain the cyanate resin and the fused silica in high amounts thereof.

Further, in Examples, the tensile modulus of each second base member at 25°C was larger than that of each first base member, In other words, each second base member had the rigidity higher than that of each first base member. Furthermore, the flexible portions of the multilayer wiring boards obtained in each of Examples and Comparative Examples had the flexibility.

### INDUSTRIAL APPLICABILITY

According to the present invention, it is possible to provide a multilayer wiring board which has excellent semiconductor element mounting reliability and superior placement flexibility, and a semiconductor device having such a multilayer wiring board. Thus, the present invention has industrial applicability.

## Claims

1. A multilayer wiring board, comprising:
a rigid portion induing a first base member having flexibility and surfaces, the first base member having a first insulating layer and a first conductor layer, and a second base member bonded on at least one of the surfaces of the first base member and having rigidity higher than that of the first base member, the second base member having a second insulating layer and a second conductor layer; and
a flexible portion provided so as to be continuously extended from the rigid portion, the flexible portion constituted from the first base member,
wherein in the case where a coefficient of thermal expansion of the second insulating layer is measured by a thermal mechanical analysis based on JIS C 6481 at a temperature of 20°C to a glass-transition temperature Tg₂ thereof [°C], which is measured using a dynamic viscoelastic apparatus based on JIS C 6481, the coefficient of thermal expansion of the second insulating layer in a plane direction thereof is 13 ppm/°C or lower and the coefficient of thermal expansion of the second insulating layer in a thickness direction thereof is 20 ppm/°C or lower.

2. The multilayer wiring board as claimed in claim 1, wherein the glass-transition temperature Tg₂ [°C] of the second insulating layer is in the range of 200 to 280°C.

3. The multilayer wiring board as maimed in claim 1, wherein the rigid portion includes two second base members bonded to both surfaces of the first base member.

4. The multilayer wiring board as claimed in claim 1, wherein in the rigid portion, the number of the first insulating layer is in the range of 1 to 4 and the number of the second insulating layer is in the range of 2 to 10.

5. The multilayer wiring board as claimed in claim 1, wherein in the case where an average thickness of the first base member is defined as X [µm] and an average thickness of the second base member is defined as Y [µm], the X and the Y satisfy a relation of 1.5 ≤ Y/X ≤ 10.

6. The multilayer wiring board as claimed in claim 1, wherein in the case where an average thickness of the second base member is defined as Y [µm] and a tensile modulus of the second base member, which is obtained by a dynamic viscoelastic measurement, at 260°C is defined as Z [GPa], the Y and the Z satisfy a relation of 530 ≤ Y·Z ≤ 4300.

7. The multilayer wiring board as claimed in claim 1, wherein the second insulating layer is mainly constituted from a fibrous core material, a resin material and an inorganic filler.

8. The multilayer wiring board as claimed in claim 7, wherein the resin material contains cyanate resin and epoxy resin, and
wherein in the case where an amount of the cyanate resin contained in the resin material is defined as A [wt%] and an amount of the epoxy resin contained in the resin material is defined as B [wt%], the A and the B satisfy a relation of 0.1 ≤ B/A ≤ 1.0.

9. The multilayer wiring board as claimed in claim 7, wherein the resin material contains cyanate resin and phenolic resin, and
wherein in the case where an amount of the cyanate resin contained in the resin material is defined as A [wt%] and an amount of the phenolic resin contained in the resin material is defined as C [wt%], the A and the C satisfy a relation of 0.1 ≤ C/A ≤ 1.0.

10. The multilayer wiring board as claimed in claim 7, wherein the core material is mainly composed of glass fibers.

11. The multilayer wiring board as maimed in claim 1. wherein the second insulating layer has a through-hole extended so as to pass through the second insulating layer in the thickness direction thereof, and a conductor post formed inside the through-hole, and
wherein the first conductor layer and the second conductor layer are electrically connected to each other via the conductor post.

12. The multilayer wiring board as claimed in claim 11, wherein the conductor post includes a protruding terminal having one end electrically connected to the second conductor layer and the other end opposite to the one end provided so as to be protruded from the second insulating layer, and a metal coating layer coating the other end of the protruding terminal and electrically connected to the first conductor layer.

13. A semiconductor device, comprising:
the multilayer wiring board defined by claim 1; and
a semiconductor element electrically connected to a predetermined portion of the second conductor layer of the multilayer wiring board.
